# EUROPEAN PATENT APPLICATION

(11) **EP 4 679 500 A1**
(43) Date of publication of application: **14.01.2026**
(21) Application number: 25179403.8
(22) Date of filing: 28.05.2025
(51) Int. Cl.: H01L 23/15, H01L 21/48, H01L 23/498, H01L 23/538

(54) **HYBRID GLASS AND ORGANIC SUBSTRATES**

(30) Priority: 28.06.2024 US 202418757657
(71) Applicant: INTEL Corporation, Santa Clara, CA 95054 (US)
(72) Inventor: ZAMANI, Ehsan, Phoenix, 85048 (US); MOUSAVI, Seyyed Yahya, Chandler, 85226 (US); KONCHADY, Manohar, Chandler, 85248 (US); BRYKS, Whitney M., Chandler, 85249 (US); CAO, Yi, Chandler, 85248 (US); DUAN, Gang, Chandler, 85248 (US); GRUJICIC, Darko, Chandler, 85249 (US); HEATON, Thomas S., Gilbert, 85234 (US); JIMENEZ, Andrew Matthew, Mesa, 85210 (US); JONES, Jesse, Chandler, 85248 (US); KAVIANI, Shayan, Phoenix, 85044 (US); KONG, Jieying, Chandler, 85286 (US); LAI, Shuqi, Phoenix, 85045 (US); LI, Yi, Chandler, 85225 (US); LIU, Minglu, Chandler, 85248 (US); LTEIF, Sandrine, Phoenix, 85048 (US); MOHAMMADIGHALENI, Mahdi, Phoenix, 85048 (US); NDUKUM, Tchefor T., Chandler, 85286 (US); NGUYEN, Son Van, Gilbert, 85296 (US); PIETAMBARAM, Srinivas Venkata Ramanuja, Chandler, 85249 (US); SENEVIRATNE, Dilan, Phoenix, 85048 (US); SHANMUGAM, Rengarajan, Tempe, 85283 (US); STACEY, Joshua J., Chandler, 85286 (US); TAVAKOLI, Elham, Phoenix, 85048 (US); VICKERY, David, Gilbert, 85297 (US); WALL, Marcel A., Phoenix, 85048 (US); WANG, Yekan, Chandler, 85286 (US); ZHANG, Anqi, Chandler, 85226 (US); OFUEGBE, James Kayode, Laveen, 85339 (US); XIE, Zhixin, Chandler, 85249 (US); HAN, Jung Kyu, Chandler, 85226 (US)
(74) Representative: HGF

(57) **Abstract**

Hybrid glass and organic substrates, devices and systems formed thereon, and methods of forming the same, are disclosed herein. In one example, a substrate includes a glass layer and an organic frame around the glass layer, where the organic frame includes a polyimide.

## Description

### BACKGROUND

The use of glass as the core of a semiconductor substrate is a promising alternative to organic materials such as copper-clad laminates (CCLs), particularly due to the high thermal stability, enhanced electrical properties, and flat and distortion-free surface provided by glass. Glass is extremely fragile, however, which presents challenges for large, extremely thin glass panels used in advanced packaging solutions, as the glass is susceptible to chips, cracks, and fractures, particularly when processed through legacy toolsets designed for substrates with organic cores (e.g., CCLs).

### BRIEF DESCRIPTION OF THE DRAWINGS

**FIGS. 1A-B** illustrate a hybrid substrate with a glass core and an organic polymer frame.
**FIGS. 2A-E** illustrate a process flow for forming a hybrid substrate with a glass core and an organic polymer frame.
**FIG. 3** illustrates the molecular structure of an example heat-resistant polymer.
**FIGS. 4A-B** illustrate a hybrid substrate with a glass core and an organic frame bonded together using a dispensable adhesive.
**FIGS. 5A-G** illustrate a process flow for forming a hybrid substrate with a glass core and an organic frame bonded together using a dispensable adhesive.
**FIGS. 6A-B** illustrate a hybrid substrate with a glass core encapsulated by a prepreg shell.
**FIGS. 7A-B** illustrate a hybrid substrate with a glass core and a prepreg frame encapsulating the edges of the glass core.
**FIGS. 8A-D** illustrate a process flow for forming a hybrid substrate with a glass core encapsulated by a prepreg shell.
**FIGS. 9A-D** illustrate a process flow for forming a hybrid substrate with a glass core and a prepreg frame encapsulating the edges of the glass core.
**FIGS. 10A-B** illustrate a hybrid substrate with an interlocking glass core and organic frame.
**FIGS. 11A-E** illustrate a process flow for forming a hybrid substrate with an interlocking glass core and organic frame.
**FIGS. 12A-E** illustrate examples of unit-level hybrid substrates singulated from hybrid glass/organic panels.
**FIGS. 13A-C** illustrate an example of a glass substrate.
**FIG. 14** illustrates an example of an integrated circuit package that may incorporate a hybrid glass/organic substrate.
**FIGS. 15A-B** illustrate example systems that may incorporate hybrid glass/organic substrates.
**FIG. 16** illustrates a process flow for packaging integrated circuits on a hybrid glass/organic substrate.
**FIG. 17** illustrates a top view of a wafer and dies that may be included in a microelectronic assembly.
**FIG. 18** illustrates a cross-sectional side view of an integrated circuit device assembly that may include a microelectronic assembly.
**FIG. 19** illustrates a block diagram of an example electrical device that may include a microelectronic assembly.

### DETAILED DESCRIPTION

The use of glass as the core of a semiconductor substrate-such as a package substrate, interposer, or printed circuit board (PCB)-is a promising alternative to organic cores such as copper-clad laminates (CCLs), particularly due to the high thermal stability, enhanced electrical properties, and flat and distortion-free surface provided by a glass core. Glass is extremely fragile, however, which is particularly problematic for the large, extremely thin glass panels used in today's advanced packaging solutions, which may be up to 600x600 millimeters (mm) in size with a thickness of only 50-100 micrometers (microns, µm) in some cases. As a result, the glass panels are very susceptible to chips, cracks, and fractures, particularly along the edges, when processed through equipment and toolsets that were designed for organic substrates (e.g., CCLs). Thus, ensuring compatibility with existing processes can be challenging, while developing new processes and toolsets can be costly and time consuming.

Accordingly, this disclosure presents various embodiments of hybrid glass and organic substrates, such as a glass core with an organic frame or shell, which can be processed using existing organic toolsets while significantly reducing the risk of damage to the glass core. The described embodiments may provide various advantages, including higher yield, lower costs, and support for well-established legacy processes and toolsets, while also realizing the benefits of glass cores over organic alternatives such as CCLs.

### Hybrid glass substrate with organic polymer frame

In some cases, a copper-clad laminate (CCL) frame may be formed around a glass core to provide protection during processing. For example, the CCL frame may be formed first, then the glass core may be placed in the middle of the CCL frame, and the CCL frame and glass core may then be laminated or molded with a dielectric film, such as Ajinomoto Build-up Film (ABF), which fills the gaps between the CCL frame and the glass core (e.g., laminated ABF between the CCL frame and glass core). In this manner, the CCL frame may strengthen the glass core and enable processability at tools that require hard mechanical and physical agitation without causing breakage. In some cases, however, the coefficient of thermal expansion (CTE) mismatch between the CCL frame and the glass core may cause warpage or separation of the CCL frame from the glass core.

Accordingly, this disclosure presents embodiments of a hybrid substrate with a glass core and an organic polymer frame (e.g., with no CCL), which can be fabricated with a simple one-step process. The organic polymer frame may be made from super heat resistant polymers with high mechanical and thermal properties (e.g., stiff polymeric materials with low CTE), including polyimides such as poly(benzoxazole imide). Moreover, the organic polymer frame can be fabricated with a simple one-step process where the glass core is placed in a framing mold and the mold is filled with the polymeric material.

The described embodiments may provide various advantages, including a novel and easy process for fabricating hybrid glass/organic panels. Unlike CCL frames, the fabrication process does not require laminated dielectric film (e.g., ABF) between the organic frame and the glass core, thus eliminating a step, simplifying the process flow, and reducing cost. Further, the organic frame can be formed using a polymeric material with a similar CTE as the glass core, thus avoiding potential warpage and separation that may occur when there is a CTE mismatch between the glass core and the organic frame (e.g., as is the case with CCL frames). The described embodiments may also provide any of the other advantages described throughout this disclosure with respect to hybrid glass/organic frames.

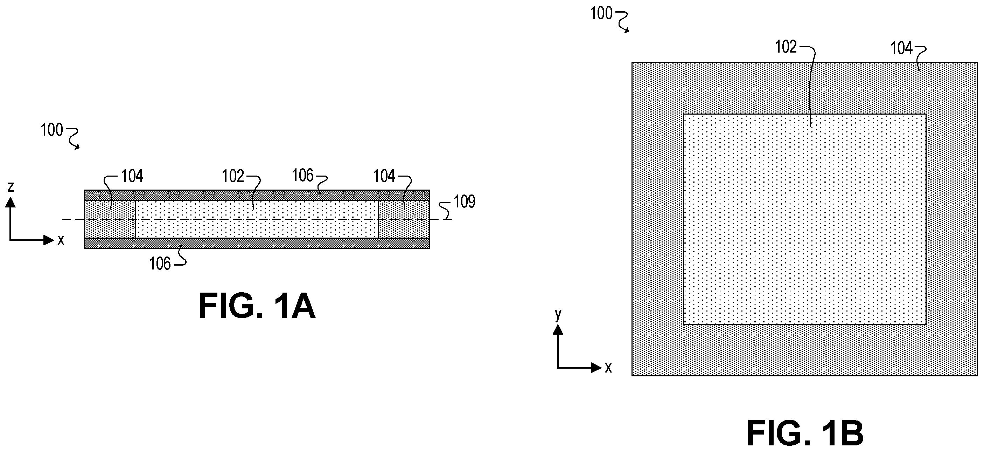

**FIGS. 1A-B** illustrate an example of a hybrid substrate 100 with a glass core 102 and an organic polymer frame 104. In the illustrated example, cross-section (x-z plane) and plan (x-y plane) views of hybrid substrate 100 are shown in FIGS. 1A and 1B, respectively, where the plan view in FIG. 1B corresponds to the cut line 109 shown in FIG. 1A.

In the illustrated embodiment, hybrid substrate 100 includes a glass core 102 with an organic polymer frame 104 around the edges or perimeter of the glass core 102 (e.g., as shown in the plan view of FIG. 1B), along with dielectric film 106 (e.g., ABF) laminated on the top and bottom surfaces/sides of the glass core 102 and the polymer frame 104.

Moreover, the organic polymer frame 104 may be made of a super heat resistant polymer with high thermal stability (e.g., low CTE) and strong mechanical properties (e.g., high stiffness), including polyimide-based polymers such as poly(benzoxazole imide)s (PBOIs). These types of polymers are super heat resistant, as they have high glass transition temperatures (T_{g}) and very low CTE. In particular, these polymers can have CTEs below 10 parts-per-million (ppm) per Kelvin (K) (ppm/K), and even as low as about 3 ppm/K, which enables the CTE of the polymer frame 104 to match with the CTE of the glass core 102. For example, the particular polymeric material used for the polymer frame 104 can be selected or tuned to match the CTE of the glass core 102, thus avoiding warpage and frame separation caused by CTE mismatch. In some embodiments, for example, the polymer frame 104 may be made of a polymer that has a CTE within 1 ppm/K of the CTE of the glass core 102.

In some embodiments, hybrid substrate 100 may be a hybrid panel, where the glass core 102 is a glass panel with an organic polymer frame 104. In this manner, hybrid panel 100 may be used as a reconstitution panel for packaging integrated circuit (IC) dies or other components using advanced packaging processes and/or organic processing lines.

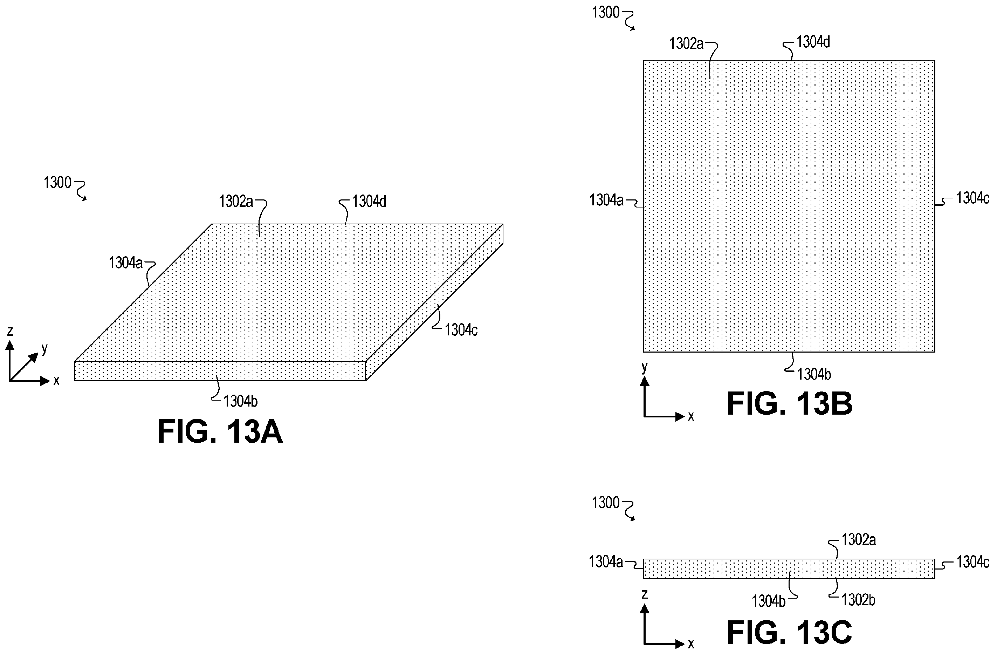

The glass core 102 may be made of any suitable glass materials, including any of the materials described in connection with glass substrate 1300 of FIGS. 13A-C.

The polymer frame 104 may be made of any suitable polymeric materials, including, without limitation, polyimides and poly(benzoxazole imide)s. Thus, in some embodiments, the polymer frame 104 may be made of materials that include elements such as carbon (C), hydrogen (H), oxygen (O), and/or nitrogen (N).

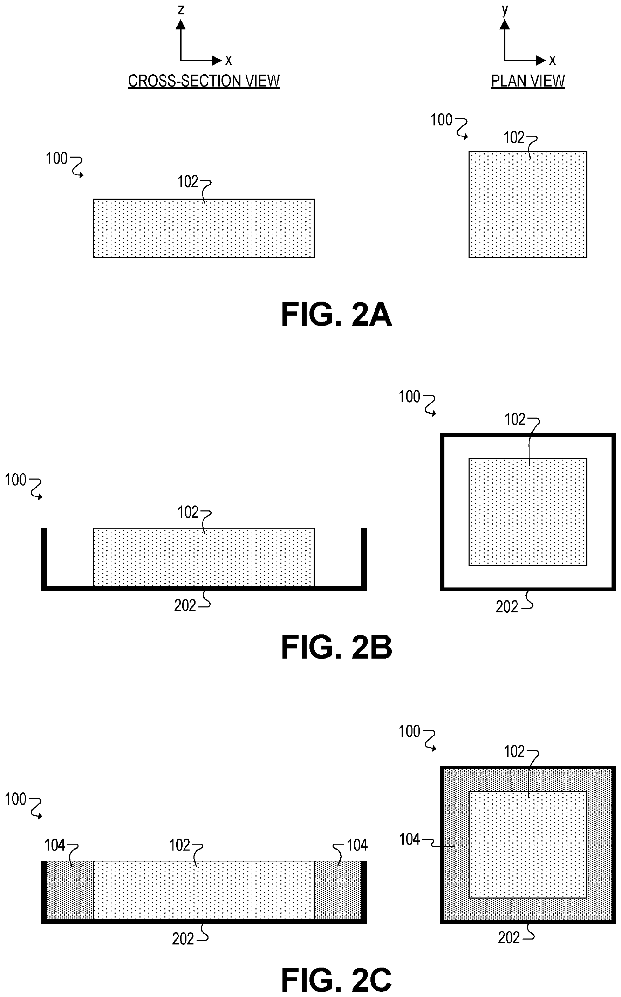

**FIGS. 2A-E** illustrate an example process flow for forming a hybrid substrate 100 with a glass core 102 and an organic polymer frame 104. In the illustrated example, FIGS. 2A-E show cross-section (x-z plane) and plan (x-y plane) views of the substrate 100 after each step of the process flow. It will be appreciated in light of the present disclosure that the illustrated process flow is only one example methodology for arriving at hybrid substrate 100.

In FIG. 2A, a glass substrate 102 is received (e.g., a glass panel, subpanel, quarter panel, unit, etc.). In some embodiments, the glass substrate 102 may have slightly smaller dimensions than the resulting hybrid substrate 100 formed at the completion of the process flow. For example, for a full-size hybrid panel 100 of 510x515 mm, the glass substrate 102 may be a glass subpanel of about 480x485 mm.

In FIG. 2B, the glass substrate 102 is placed in a framing mold 202. In some embodiments, the framing mold 202 may be a mold frame or box with the same or similar dimensions as the resulting hybrid substrate 100. For example, for a full-size hybrid panel 100 of 510x515 mm, the framing mold 202 may be a box with dimensions of about 510x515 mm (or slightly larger).

In FIG. 2C, a heat-resistant polymer (e.g., with low CTE and high stiffness) is injected into the mold 202, thus filling the empty areas of the mold 202 with the polymer. In some embodiments, the heat-resistant polymer may be a polyimide or poly(benzoxazole imide) (PBOI). Moreover, the particular polymer may be selected such that it strongly attaches to the glass substrate 102.

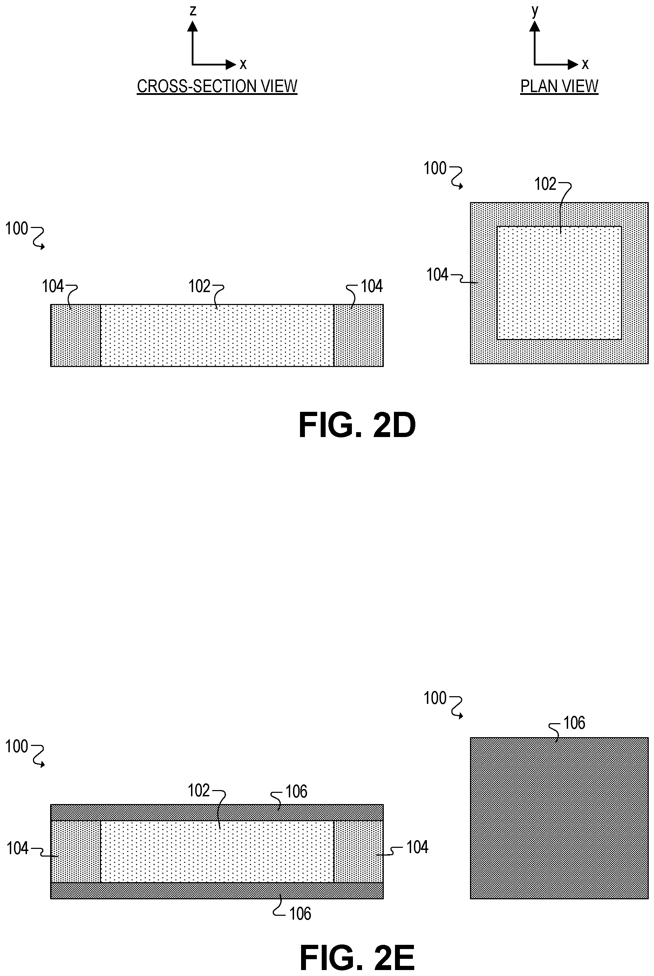

In FIG. 2D, the polymer 104 is annealed, and the mold 202 is removed from the hybrid substrate 100 (e.g., the glass substrate 102 and the polymer 104). In this manner, the hybrid substrate 100 includes an organic polymer layer or frame 104 that extends around the edges or perimeter of the glass core 102 (e.g., in plan view). Further, as shown in the cross-section view, there is no dielectric film or laminate (e.g., ABF) between the organic frame 104 and the glass core 102 (e.g., unlike CCL frames, which require dielectric film for adhesion between the CCL frame and glass core).

In FIG. 2E, the hybrid substrate 100 is laminated with dielectric film 106 (e.g., ABF) on both sides (e.g., on the top/bottom surfaces of the glass substrate 102 and polymer frame 104). Alternatively, in some embodiments, the glass substrate 102 may be laminated on both sides before the polymer frame 104 is formed (e.g., before the glass substrate 102 is placed in the mold 202 in FIG. 2B).

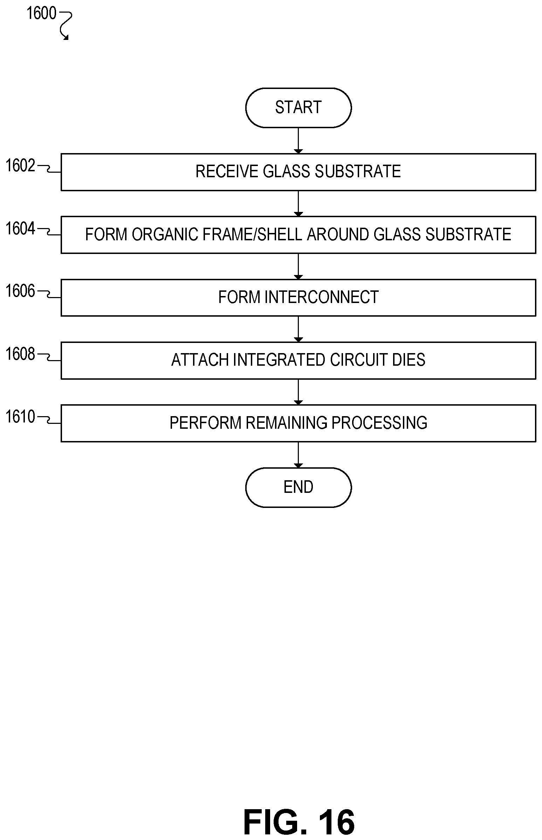

At this point, the hybrid substrate 100 may be complete, and the remaining processing may be performed, such as via formation (e.g., forming through-glass vias (TGVs) through the glass core 102), interconnect patterning (e.g., forming dielectric buildup layers and conductive layers, patterning the conductive layers into traces, forming vias), die attach, interconnect bump formation, singulation, etc. (e.g., as described further in connection with process flow 1600 of FIG. 16).

Since the organic frame 104 is made of a heat-resistant polymer with low CTE and high mechanical properties, the hybrid substrate 100 can survive hard mechanical processes during the remaining processing. Moreover, due to the matched CTE between the polymer frame 104 and the glass core 102, defects like warpage and separation between the frame 104 and glass core 102 may be avoided.

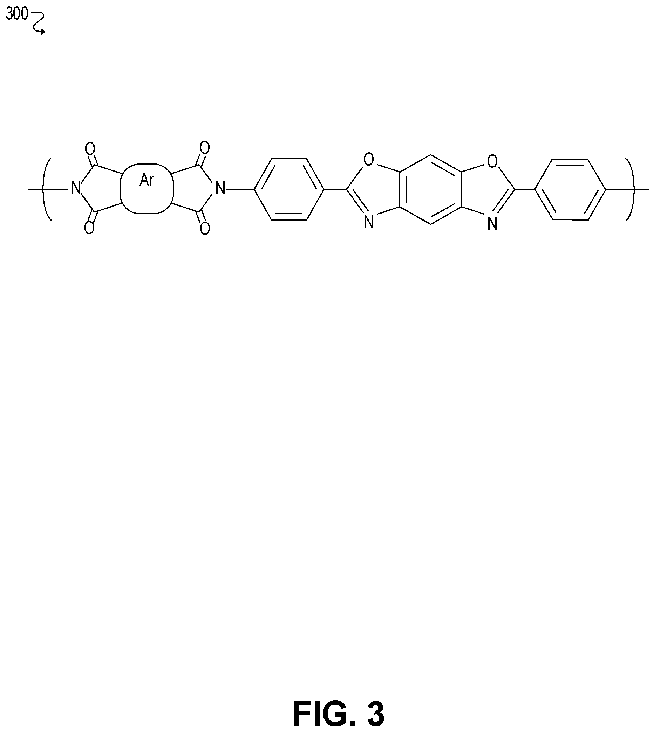

**FIG.3** illustrates the molecular structure 300 of an example heat-resistant polymer, which may be used to form the organic polymer frame 104 of hybrid substrate 100. In the illustrated example, the polymer may be a polyimide-based polymer such as poly(benzoxazole imide) (PBOI), which is a heat-resistant polymer with low CTE and high mechanical properties. Polyimide is a polymer of imide monomers, with repeating imide groups (e.g., -CO-N-CO-) in its molecular structure, which has exceptional thermal stability and mechanical properties. Poly(benzoxazole imide) (PBOI) is a polymer that incorporates both benzoxazole groups (e.g., aromatic (Ar) rings with nitrogen and oxygen) and imide groups (e.g., -CO-N-CO-) in its molecular structure, thus combining the benefits of both parent polymers.

### Hybrid glass substrate with organic frame bonded using dispensable adhesive

While the use of glass substrates for semiconductor packaging provides various technological benefits, the fragility of large form factor glass panels (e.g., panels with dimensions of 510x525 mm, 600x600 mm) may lead to defects during processing, which reduces yield and increases costs. For example, as a glass panel is contacted by various toolsets throughout a processing line, minor defects (e.g., chips) may arise along the edges of the glass panel, which may eventually lead to breaks or fractures in the panel. Upgrading equipment and overhauling the process flow for glass panels to reduce defects and improve yield can be very costly.

In some cases, to protect the edges of a glass panel, material can be dispensed to encapsulate the panel, provide reinforcement, and fill any gaps or cavities between the panel and an organic frame, if used. In this manner, the protected edges may allow the glass panel to be processed through standard organic toolsets without chipping or breaking.

For example, in the case of hybrid reconstitution, ABF or mold material is typically spread or placed across a glass panel and subsequently pressed into the gap or cavity between the panel and the protective frame. This process requires specific material placement toolsets and recipe tuning to even out the flow of material with the rest of the panel, while also placing limitations on the type of material used to fill the gap/cavity between the panel and frame.

Accordingly, this disclosure presents embodiments of a hybrid substrate with a glass core and an organic frame bonded together using a dispensable (e.g., low-viscosity, flowable) adhesive, such as an epoxy. For example, the low-viscosity adhesive can be dispensed into the gap or cavity between the glass core and the frame using a syringe-style dispenser, or alternatively, a squeegee-style blade with a matching stencil. In this manner, the material used to fill the gap between the frame and glass core can differ from the material used to form the dielectric buffer or buildup layers on the substrate. For example, the gap between the glass core and the frame may be filled with a material (e.g., an epoxy) that provides more flexible and durable edge protection combined with strong adhesion to hold the glass core and the frame together, while the dielectric buildup layers may be formed using a dielectric film such as ABF.

The described embodiments may provide various advantages. For example, this process flow provides greater flexibility to select different types of materials for edge protection versus buildup layers, thus enabling optimal materials to be used for each. This process flow also provides more control over the filling the gap between glass/frame as a separate step from the buffer lamination, which helps ensure a better total thickness variation (TTV) across the panel. Further, the resulting hybrid reconstitution panel can be processed through existing organic toolsets without chipping or breaking. The described embodiments may also provide any of the other advantages described throughout this disclosure with respect to hybrid glass/organic frames.

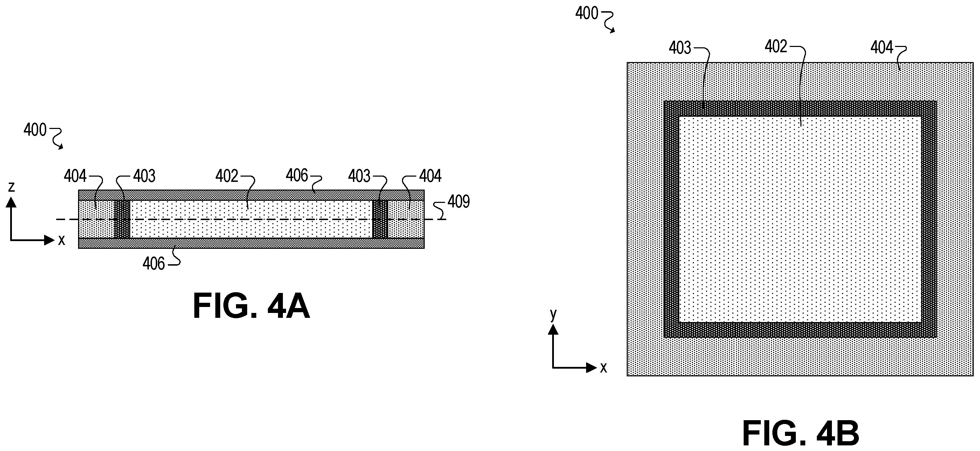

**FIGS. 4A-B** illustrate an example of a hybrid substrate 400 with a glass core 402 and an organic frame 404 bonded together using a dispensable (e.g., low-viscosity) adhesive 403, such as an epoxy. In the illustrated example, cross-section (x-z plane) and plan (x-y plane) views of hybrid substrate 400 are shown in FIGS. 4A and 4B, respectively, where the plan view in FIG. 4B corresponds to the cut line 409 shown in FIG. 4A.

In the illustrated embodiment, hybrid substrate 400 includes a glass core 402, an organic layer or frame 404 extending around the edges or perimeter of the glass core 402, and an adhesive layer 403 between the glass core 402 and the organic frame 404 that bonds them together (e.g., as shown in the plan view of FIG. 4B). Further, the top and bottom surfaces/sides of hybrid substrate 400 are laminated with dielectric film 406 such as ABF (e.g., on the glass core 402, the frame 404, and the adhesive layer 403).

In some embodiments, the adhesive layer 403 may be made of a cured adhesive material that has relatively low viscosity in its uncured or wet form (e.g., a flowable or fluid adhesive material that can be dispensed and is curable), such as an epoxy.

In this manner, rather than pushing mold or ABF into the gap between the glass core 402 and the organic frame 404, a more precise method can be used to control the dispensing of a dielectric adhesive material 403 that is better suited to protect the edges of the glass core 402 and bond the frame 404 to the glass core 402. For example, epoxy dispense tools (e.g., syringe/nozzle-based dispensers) are common in the industry and provide high precision with respect to the position/mass of dispensed material (e.g., compared to mold tools which are much more limited and less precise), thus enabling a low-viscosity epoxy 403 to be dispensed into the gap region between the frame 404 and the glass core 402. Alternatively, squeegee-type dispensing tools (e.g., a squeegee blade in conjunction with a patterned stencil) can also be used to target the specific gap region to fill it with a low viscosity, curable material.

The use of a lower-viscosity material 403 also provides benefits of better toughness and elongation compared to currently used ABF/mold-type materials, which are brittle and often require additional layers to provide reinforcement and prevent cracking.

In some embodiments, hybrid substrate 400 may be a hybrid panel, where the glass core 402 is a glass panel with an organic frame 404 and an adhesive layer 403 around the glass core panel 402. In this manner, hybrid panel 400 may be used as a reconstitution panel for packaging integrated circuit (IC) dies or other components using advanced packaging processes and/or organic processing lines.

The glass core 402 may be made of any suitable glass material, including any of the materials described in connection with glass substrate 1300 of FIGS. 13A-C.

The adhesive layer 403 may be made of any suitable adhesive material with relatively low viscosity in wet or uncured form that can be cured or hardened (e.g., flowable or fluid adhesive materials that are curable), including, without limitation, epoxies (e.g., capillary underfill (CUF) epoxies) with or without additives. In some embodiments, for example, an epoxy used in the adhesive layer 403 may include elements such as carbon (C), hydrogen (H), oxygen (O), nitrogen (N), and/or chlorine (Cl), optionally with additives that include element such as silicon (Si), sulfur (S), and/or phosphorous (P).

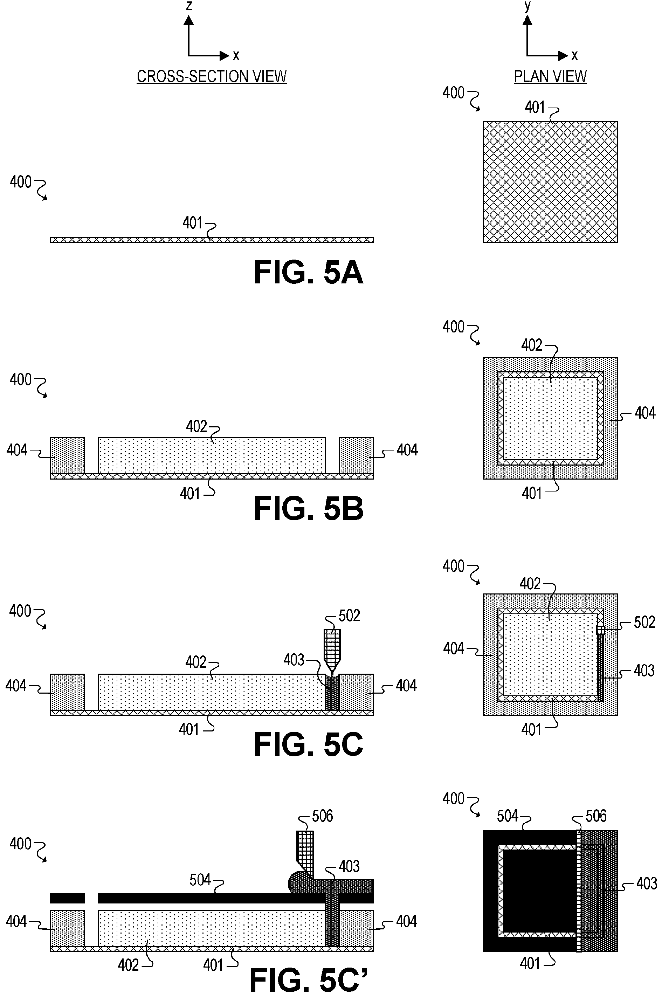

**FIGS. 5A-G** illustrate an example process flow for forming a hybrid substrate 400 with a glass core 402 and an organic frame 404 bonded together using a dispensable (e.g., low-viscosity) adhesive 403. In the illustrated example, FIGS. 5A-G show cross-section (x-z plane) and plan (x-y plane) views after each step of the process flow. It will be appreciated in light of the present disclosure that the illustrated process flow is only one example methodology for arriving at hybrid substrate 400.

In FIG. 5A, a releasable carrier layer 401 is received or formed. For example, the carrier layer 401 may be a thin layer of release film or release tape, or alternatively, the carrier layer 401 may be a releasable carrier substrate (e.g., a rigid panel-level carrier substrate that can release).

In FIG. 5B, a glass substrate 402 (e.g., glass panel, subpanel, quarter panel, etc.) and an organic frame 404 are received and then arranged on the carrier 401 (e.g., via pick and place), such that the glass substrate 402 is substantially centered within the organic frame 404 (e.g., where the organic frame 404 extends around the glass substrate 402), with a gap separating the organic frame 404 and the glass substrate 402.

In FIG. 5C, a syringe-style dispenser 502 is used to dispense a low-viscosity wet adhesive material 403 (e.g., a curable epoxy that is flowable or fluid in wet/uncured form) into the gap between the glass substrate 402 and the organic frame 404, thus filling the gap with the adhesive material 403.

Alternatively, in FIG. 5C', a squeegee-style blade 506 and a corresponding stencil 504 are used to dispense the low-viscosity adhesive material 403 into the gap between the glass substrate 402 and the organic frame 404, thus filling the gap with the adhesive material 403. For example, the stencil 504 may be patterned with openings or apertures corresponding to the gap between the glass substrate 402 and the frame 404. Moreover, the stencil 504 may be placed over the substrate 400, and the squeegee blade 506 may be used to spread the adhesive material403 over the stencil 504 and into the gap between the glass substrate 402 and frame 404.

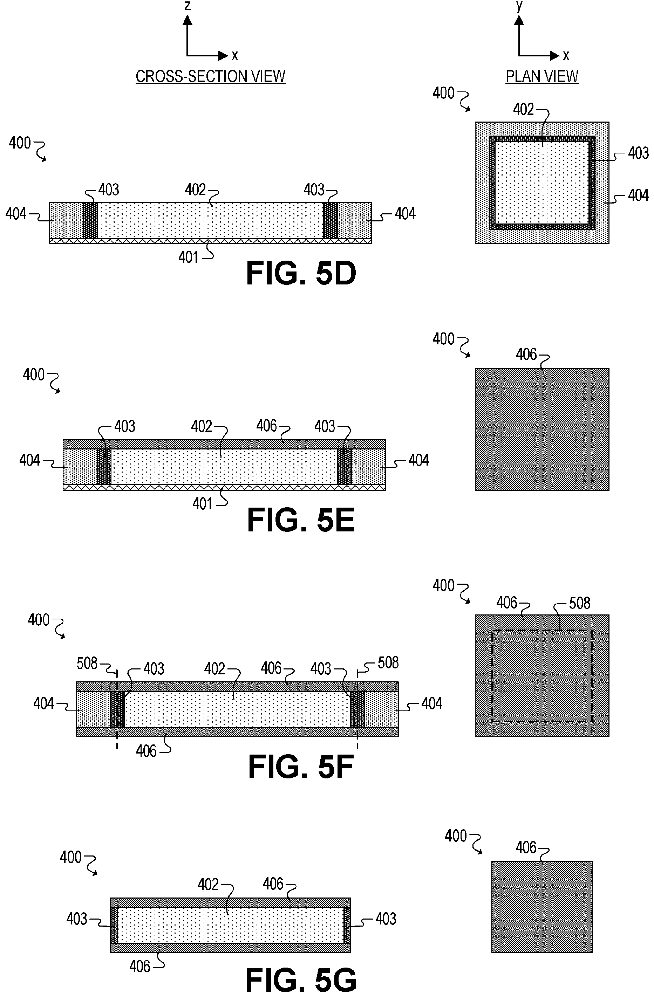

In FIG. 5D, the adhesive material 403 is cured, thus forming an adhesive layer 403 in the gap between the glass substrate 402 and the organic frame 404. In this manner, the adhesive layer 403 and the organic frame 404 extend around the edges or perimeter of the glass substrate 402 in plan view, with the adhesive layer 403 bonding the frame 404 to the glass substrate 402.

After curing the adhesive material 403, the process may continue with standard buildup layers (e.g., dielectric layer 406) across the hybrid substrate 400 (e.g., as shown in FIGS. 5E and 5F).

In FIG. 5E, for example, the top surface of the hybrid substrate 400 is laminated with dielectric film 406 such as ABF (e.g., over the glass substrate 402, the organic frame 404, and the adhesive layer 403). In some embodiments, the remaining buildup layers on the frontside of the hybrid substrate 400 may be formed at this point. Alternatively, the remaining frontside buildup layers may be formed in FIG. 5G after the outer protective frame 404 is removed in FIG. 5F.

At this point, the hybrid substrate 400 may be stable enough to stand alone, thus enabling removal of the carrier 401 and formation of backside buildup layers (e.g., dielectric layer 406) on the hybrid substrate 400.

In FIG. 5F, for example, the hybrid substrate 400 is separated or removed from the carrier 401, and the bottom surface of the hybrid substrate 400 is laminated with dielectric film 406 such as ABF (e.g., under the glass substrate 402, the organic frame 404, and the adhesive layer 403). In some embodiments, the remaining buildup layers on the backside of the hybrid substrate 400 may be formed at this point. Alternatively, the remaining backside buildup layers may be formed in FIG. 5G (e.g., after the outer protective frame 404 is removed).

At this point, the outer frame 404 may be removed from, or cut off, the hybrid substrate 400 (e.g., by dicing/cutting the substrate 400 along cut line 508).

In FIG. 5G, the hybrid substrate 400 includes the glass core 402 (e.g., panel, quarter panel, or unit level), with some protected edges 403 still present and buildup layers 406 over the glass core 402 and the edges 403. In particular, after cutting the outer frame 404 off the hybrid substrate 400, the edges of the glass substrate 402 remain protected by the adhesive 403 (potentially along with any remaining portions or residue of the organic frame 404, depending on where the cuts 408 are made in FIG. 5F).

At this point, any remaining processing may be performed (if not already performed in prior steps), such as via formation (e.g., forming through-glass vias (TGVs) through the glass core 102), interconnect patterning (e.g., forming dielectric buildup layers and conductive layers, patterning the conductive layers into traces, forming vias), die attach, interconnect bump formation, singulation, etc. (e.g., as described further in connection with process flow 1600 of FIG. 16).

### Hybrid glass substrate with prepreg reinforcement

As described throughout this disclosure, bare glass panels are not suitable for processing through organic processing lines due to the risk of damage around the edges of the glass panels during processing.

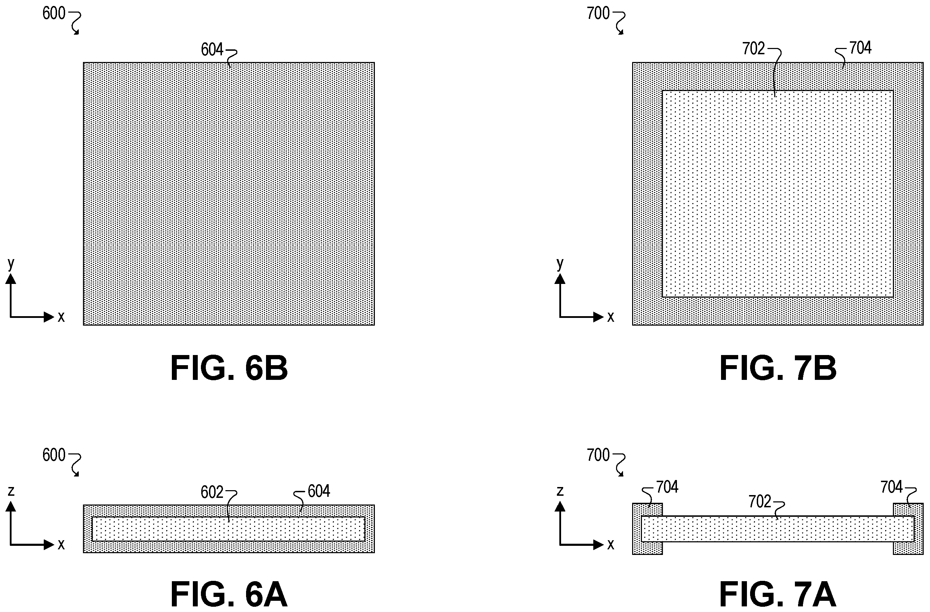

Accordingly, this disclosure presents embodiments of a hybrid substrate with a glass core and prepreg (PPG) reinforcement around all or some of the glass core. In some embodiments, for example, the glass core may be fully encapsulated by an organic prepreg shell (e.g., as shown in FIGS. 6A-B), or alternatively, the edges of the glass core may be encapsulated by an organic prepreg frame (e.g., as shown in FIGS. 7A-B).

In this manner, a hybrid glass panel with prepreg reinforcement can be processed through an organic processing line. In particular, the prepreg material, which may encapsulate either the entire glass panel or the edges of the glass panel, acts as buffer that may absorb any impact or shock during processing, thus protecting the glass panel from damage.

The described embodiments may provide various advantages. For example, the described embodiments may provide panel-level edge protection for glass panels using prepreg reinforcement and encapsulation, thus enabling hybrid glass/organic panels to be processed through existing organic processing lines (e.g., using legacy tools for organic substrates) without chipping or breaking, which increases yield and reduces costs. The described embodiments can also be used with any other sizes of glass substrates, including glass subpanels, quarter panels, units, etc. Due to the reinforcement provided by the prepreg buffer on the glass core, the hybrid glass/prepreg substrate may be significantly stronger than bare glass (e.g., approximately twice as strong in some cases). The described embodiments may also provide any of the other advantages described throughout this disclosure with respect to hybrid glass/organic frames.

**FIGS. 6A-B** illustrate an example of a hybrid substrate 600 with a glass core 602 fully encapsulated by an organic prepreg shell604. In the illustrated example, cross-section (x-z plane) and plan (x-y plane) views of hybrid substrate 600 are shown in FIGS. 6A and 6B, respectively.

In the illustrated embodiment, hybrid substrate 600 includes a glass core 602, which is fully encapsulated by an organic prepreg layer or shell 604. In particular, the prepreg shell 604 encapsulates the top and bottom surfaces and all four edges of the glass core 602.

In some embodiments, hybrid substrate 600 may be a hybrid panel, where the glass core 602 is a glass panel encapsulated by an organic shell 604. In this manner, hybrid panel 600 may be used as a reconstitution panel for packaging integrated circuit (IC) dies or other components using advanced packaging processes and/or organic processing lines.

**FIGS. 7A-B** illustrate an example of a hybrid substrate 700 with a glass core 702 and an organic prepreg frame 704 encapsulating the edges of the glass core 702. In the illustrated example, cross-section (x-z plane) and plan (x-y plane) views of hybrid substrate 700 are shown in FIGS. 7A and 7B, respectively.

In the illustrated embodiment, hybrid substrate 700 includes a glass core 702, along with an organic prepreg layer or frame 704 encapsulating the edges of the glass core 702. In particular, the prepreg frame 704 encapsulates the edges of the glass core 702 on all four sides and on portions of the top and bottom surfaces near the edges of the glass core 702 (e.g., extending around the edges or perimeter of the glass core 702 in plan view).

In some embodiments, hybrid substrate 700 may be a hybrid panel, where the glass core 702 is a glass panel with an organic frame 704 encapsulating the edges of the glass panel 702. In this manner, hybrid panel 700 may be used as a reconstitution panel for packaging integrated circuit (IC) dies or other components using advanced packaging processes and/or organic processing lines.

In hybrid substrates 600 and 700, the glass core 602, 702 may be made of any suitable glass materials, including any of the materials described in connection with glass substrate 1300 of FIGS. 13A-C.

The organic shell 604 and organic frame 704 may be made of any suitable organic material(s), including, without limitation, prepreg (PPG). As used herein, prepreg (PPG) may refer to a material that includes a fibrous material, such as glass fibers or fiberglass, embedded in a resinous organic material, such as an epoxy (e.g., glass fibers "pre-impregnated" with resin). In some embodiments, the fibers in prepreg may include any of the materials and elements discussed below with respect to glass materials in glass substrate 1300, and the resin in prepreg may include elements such as carbon (C), hydrogen (H), oxygen (O), nitrogen (N), chlorine (Cl), and/or phosphorus (P).

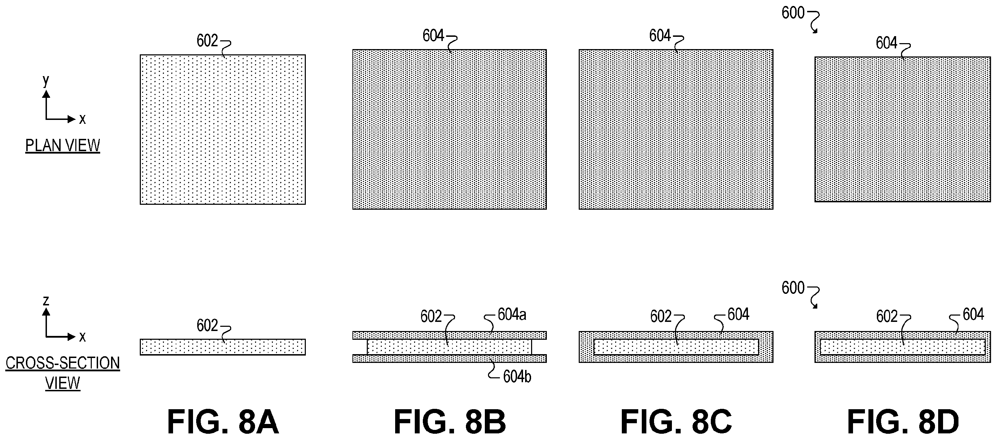

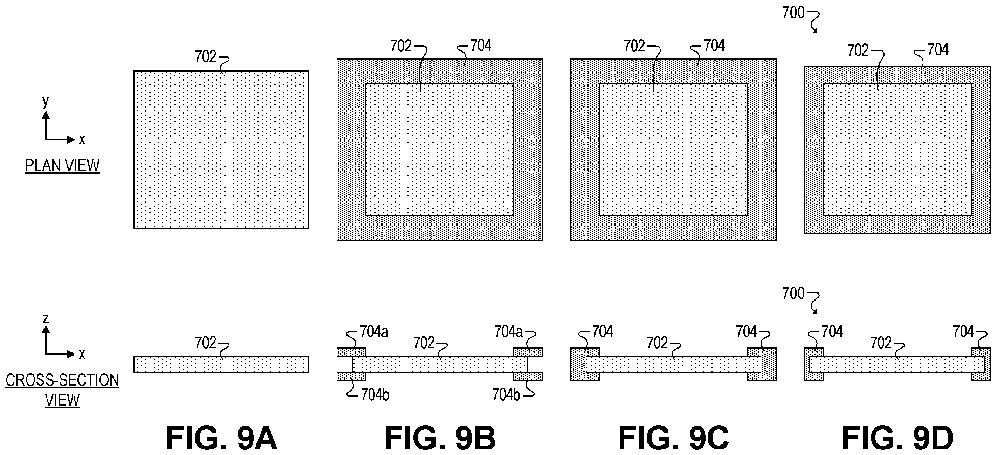

Example process flows for forming hybrid substrates 600 and 700 are described below in connection with FIGS. 8A-D and FIGS. 9A-D, respectively.

**FIGS. 8A-D** illustrate an example process flow for forming a hybrid substrate 600 with a glass core 602 encapsulated by an organic prepreg shell 604. In the illustrated example, FIGS. 8A-D show cross-section (x-z plane) and plan (x-y plane) views after each step of the process flow. It will be appreciated in light of the present disclosure that the illustrated process flow is only one example methodology for arriving at hybrid substrate 600.

In FIG. 8A, an incoming glass substrate 602 is received (e.g., a glass panel, subpanel, quarter panel, etc., with a thickness of 50 µm - 200 µm or more).

In FIG. 8B, the glass substrate 602 is arranged between two full sheets of organic prepreg material604a,b. In particular, the organic prepreg sheets 604a,b are aligned on each side of the glass substrate 602 (e.g., on the top and bottom surfaces), such that the glass substrate 602 is sandwiched between the respective prepreg sheets 604a,b. In this manner, the full sheets of prepreg 604a,b will provide full coverage or encapsulation around the glass substrate 602 once they are pressed in FIG. 8C.

In FIG. 8C, for example, the prepreg sheets 604a,b and the glass substrate 602 are pressed together at high temperature and pressure (e.g., using a hot press), which causes the prepreg resin 604 to flow around the edges and sides of the glass substrate 602, thus fully encapsulating the glass substrate 602.

In FIG. 8D, one or more edges of the prepreg shell 604 may be trimmed using a cutting tool (e.g., laser, disc cutter, etc.) to remove any excess prepreg flow. In some embodiments, after trimming the edges of the prepreg shell 604, the hybrid substrate 600 may be approximately 50 to 300 µm thick (e.g., including the glass substrate 602 and the prepreg shell 604), depending on the thickness of the glass substrate core 602.

At this point, the hybrid substrate 600 may be complete. For example, the hybrid substrate 600 includes a glass core 602, which is fully encapsulated by a (trimmed) prepreg organic layer or shell 604.

Moreover, any remaining processing may be performed on the hybrid substrate 600, such as via formation (e.g., forming through-glass vias (TGVs) through the glass core 602), interconnect patterning (e.g., forming dielectric buildup layers and conductive layers, patterning the conductive layers into traces, forming vias), die attach, interconnect bump formation, singulation, etc. (e.g., as described further in connection with process flow 1600 of FIG. 16).

**FIGS. 9A-D** illustrate an example process flow for forming a hybrid substrate 700 with a glass core 702 and an organic prepreg frame 704 encapsulating the edges of the glass core 702. In the illustrated example, FIGS. 9A-D show cross-section (x-z plane) and plan (x-y plane) views after each step of the process flow. It will be appreciated in light of the present disclosure that the illustrated process flow is only one example methodology for arriving at hybrid substrate 700.

In FIG. 9A, an incoming glass substrate 702 is received (e.g., a glass panel, subpanel, quarter panel, etc., with a thickness of 50 µm - 200 µm or more).

In FIG. 9B, the glass substrate 702 is arranged between strips of organic prepreg frame material 704a,b. In particular, each strip of organic frame 704a,b may include one or more strips of organic prepreg material arranged in the shape of a frame. Moreover, the strips of organic frame 704a,b are aligned on each side of the glass substrate 702 (e.g., on the top and bottom surfaces), such that the glass substrate 702 is sandwiched between the respective strips of organic frame 704a,b. In this manner, the organic frame strips 704a,b will provide encapsulation around the edges of the glass substrate 702 once they are pressed in FIG. 9C.

In FIG. 9C, for example, the strips of organic frame 704a,b and the glass substrate 702 are pressed together at high temperature and pressure (e.g., using a hot press), which causes the prepreg resin 704 to flow around the edges and sides of the glass substrate 702, thus fully encapsulating the edges of the glass substrate 702.

In FIG. 9D, one or more edges of the prepreg frame 704 may be trimmed using a cutting tool (e.g., laser, disc cutter, etc.) to remove any excess prepreg flow. In some embodiments, after trimming the edges of the prepreg frame 704, the hybrid substrate 700 may be approximately 200 to 300 µm thick (e.g., including the glass substrate 702 and the prepreg frame 704).

At this point, the hybrid substrate 700 may be complete. For example, the hybrid substrate 700 includes a glass core 702 with a (trimmed) prepreg organic layer or frame 704 encapsulating the edges of the glass core 702.

Moreover, any remaining processing may be performed on the hybrid substrate 700, such as via formation (e.g., forming through-glass vias (TGVs) through the glass core 702), interconnect patterning (e.g., forming dielectric buildup layers and conductive layers, patterning the conductive layers into traces, forming vias), die attach, interconnect bump formation, singulation, etc. (e.g., as described further in connection with process flow 1600 of FIG. 16).

### Hybrid glass substrate with interlocking organic frame

As described throughout this disclosure, glass panels are highly susceptible to damage, such as chipped edges and fractures, when processed using legacy (e.g., organic) process tools, which results in lower yield and higher costs. As a result, processing glass panels without damaging them may require developing new glass handling equipment or upgrading legacy tools to support glass handling.

Accordingly, this disclosure presents embodiments of a hybrid substrate with an interlocking glass core and organic frame, along with new dispensing equipment for manufacturing the same, including a custom mold frame and associated dispenser tool.

In some embodiments, for example, the hybrid substrate may include a glass core with an organic frame extending around the edges or perimeter of the glass core, along with interlocking corners and/or edges between the glass core and the organic frame. In particular, the corners and/or edges of the glass core and the organic frame may have complementary interlocking patterns, such as chamfered corners and/or beveled edges, to strengthen the interface between the glass core and organic frame.

In this manner, due to the protection provided by the interlocking organic frame, the hybrid substrate can be processed using legacy tools for organic substrates without damaging the glass core. For example, in some embodiments, the hybrid substrate may be a full-size hybrid panel with an interlocking glass subpanel and organic frame, which may be processed through a legacy organic processing line without damaging the glass subpanel.

Moreover, in some embodiments, the hybrid substrate may be fabricated using a custom two-piece mold frame with an associated dispenser. For example, a glass substrate with patterned corners and edges (e.g., chamfered corners and beveled edges) may be placed in the mold frame, an organic material (e.g., liquid prepreg) may be dispensed into the mold frame-thus filling the mold frame with organic material around the glass substrate-and the organic material may be cured to form an organic frame around the glass substrate. In this manner, the organic frame is formed around the patterned corners and edges on the glass substrate, thus forming complementary interlocking patterns on the inner corners and edges of the organic frame (e.g., such that the respective corners and edges on the glass substrate and the organic frame interlock with each other).

The described embodiments may provide various advantages. For example, the custom dispensing equipment (e.g., mold frame and dispenser) enables the hybrid substrates to be produced in high volume manufacturing (HVM) capacity. Moreover, the hybrid substrates can be processed through existing organic processing lines (e.g., using legacy tools for organic substrates) without chipping or breaking the glass core, which results in higher yield and lower costs. The hybrid substrates can also be formed without any step height on the surface (e.g., between the glass core and the organic frame), as the organic frame and glass core can be formed with the same thicknesses and flush surfaces. Further, the hybrid substrate can be routed with notches on the organic frame to identify the hybrid substrate (e.g., panel ID, type of substrate, orientation, etc.), which is challenging for bare glass substrates. The described embodiments may also provide any of the other advantages described throughout this disclosure with respect to hybrid glass/organic frames.

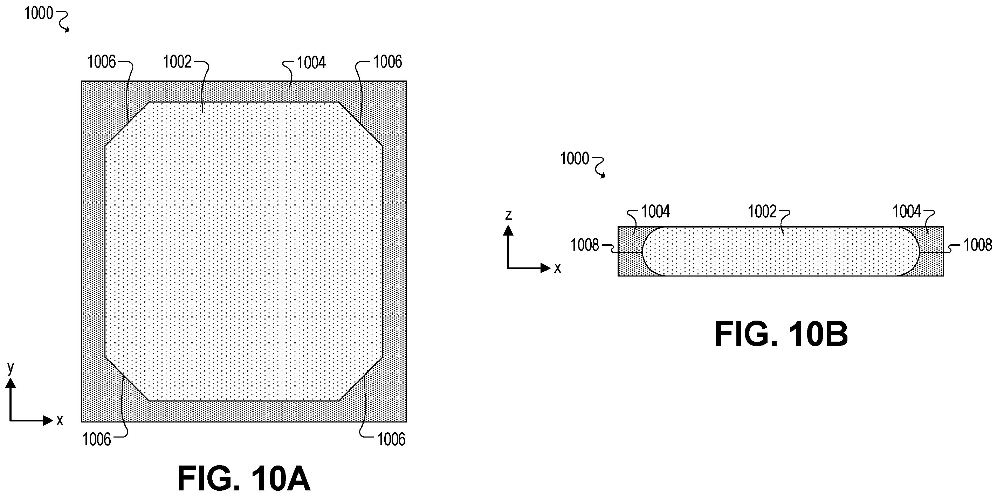

**FIGS. 10A-B** illustrate an example of a hybrid substrate 1000 with an interlocking glass core 1002 and organic frame 1004. In the illustrated example, plan (x-y plane) and cross-section (x-z plane) views of hybrid substrate 1000 are shown in FIGS. 10A and 10B, respectively.

In the illustrated embodiment, hybrid substrate 1000 includes an interlocking glass core 1002 and organic layer or frame 1004, where the organic frame 1004 extends around the edges or perimeter of the glass core 1002 (e.g., as shown in the plan view of FIG. 10A), and the glass core 1002 and the organic frame 1004 have interlocking corners 1006 and edges 1008. In this manner, the organic frame 1004 protects the edges of the glass core 1002, while the interlocking corners 1006 and edges 1008 strengthen the interface or bond between the glass core 1002 and the organic frame 1004.

In the illustrated embodiment, for example, the corners 1006 and edges 1008 between the glass core 1002 and the organic frame 1004 have complementary interlocking patterns. In particular, the respective corners 1006 of the glass core 1002 and the organic frame 1004 have complementary interlocking chamfers (e.g., as shown in the plan view of FIG. 10A), and the respective edges 1008 of the glass core 1002 and the organic frame 1004 have complementary interlocking bevels (e.g., as shown in the cross-section view of FIG. 10B),

Moreover, in the illustrated embodiment, there is no step height on the surface of the hybrid substrate 1000 between the glass core 1002 and the organic frame 1004, as the organic frame 1004 and the glass core 1002 have substantially the same thicknesses and their surfaces are substantially flush (e.g., as shown in the cross-section view of FIG. 10B). In addition, there is no gap nor material between the interlocking edges 1008 of the organic frame 1004 and the glass core 1002 (e.g., as shown in the cross-section view of FIG. 10B).

In some embodiments, hybrid substrate 1000 may be a hybrid panel with an interlocking glass subpanel 1002 and organic frame 1004 (e.g., where the frame 1004 extends around the edges/perimeter of the glass subpanel 1002, and the corners 1006 and edges 1008 of the glass subpanel 1002 and the organic frame 1004 interlock). For example, the glass subpanel 1002 may be slightly smaller than a full-size glass panel (e.g., 480x485 mm instead of 510x515 mm), while the hybrid panel 1000-which includes the glass subpanel 1002 and the organic frame 1004-may be a full-size panel (e.g., 510x515 mm). Moreover, in some embodiments, notches (not shown) may be cut or routed on the organic frame 1004 to identify the hybrid substrate 1004 (e.g., panel ID, type of substrate, orientation, etc.). In this manner, hybrid panel 1000 may be used as a reconstitution panel for packaging integrated circuit (IC) dies or other components using advanced packaging processes and/or organic processing lines.

The glass core 1002 may be made of any suitable glass materials, including any of the materials described in connection with glass substrate 1300 of FIGS. 13A-C.

The organic frame 1004 may be made of any suitable organic material(s), including, without limitation, prepreg (e.g., fiberglass and resin), organic polymers, epoxies, and/or resins. In some embodiments, the organic frame 1004 may be made of an organic material with relatively low viscosity in wet or uncured form that can be cured or hardened (e.g., liquid, fluid, flowable, dispensable organic polymers that are curable, such as liquid prepreg). Moreover, in some embodiments, the organic material may have high thermal stability, with a coefficient of thermal expansion (CTE) below 10 parts-per-million per Kelvin (ppm/K), such that the CTE of the organic frame 1004 is similar to the CTE of the glass core 1002 (e.g., within 1 ppm/K in some embodiments).

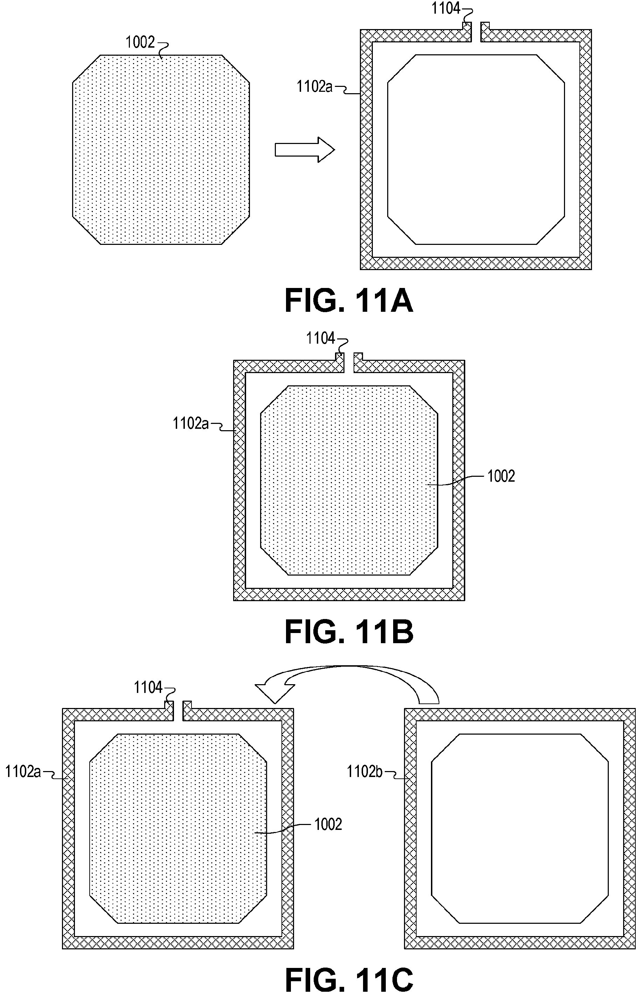

**FIGS. 11A-E** illustrate an example process flow for forming a hybrid substrate 1000 with an interlocking glass core 1002 and organic frame 1004. In the illustrated example, FIGS. 11A-E show plan views (x-y plane) after each step of the process flow. It will be appreciated in light of the present disclosure that the illustrated process flow is only one example methodology for arriving at hybrid substrate 1000.

In FIG. 11A, a glass substrate 1002 is received. In some embodiments, the glass substrate 102 may have slightly smaller dimensions than the resulting hybrid substrate 1000 formed by the process flow. For example, for a full-size hybrid panel 1000 of 51Ox515 mm, the glass substrate 1002 may be a glass subpanel of about 480x485 mm.

Moreover, as described above with respect to FIGS. 10A-B, the glass substrate 1002 may have patterned corners (e.g., in plan view) and/or patterned edges (e.g., in cross-section view). In some embodiments, for example, the patterned corners may be chamfered (e.g., chamfered corners or corners with chamfers), and the patterned edges may be beveled (e.g., beveled edges or edges with bevels), although other types of corner and edge patterns may be used in other embodiments.

Alternatively, in some embodiments, the glass substrate 1002 may be received without patterned corners or edges, and the patterned corners and/or edges may subsequently be formed on the glass substrate 1002.

Moreover, the glass substrate 1002 is aligned and placed in the center/middle of a bottom mold frame 1102a, which is the bottom portion of a two-piece closed mold frame that includes a bottom frame 1102a and a top frame or lid 1102b (collectively, mold frame 1102). In some embodiments, the dimensions of the mold frame 1102 may be tailored to form a hybrid substrate with particular dimensions (e.g., length, width, height/thickness). However, mold frames 1102 with varying dimensions may be exchanged in and out to form hybrid substrates with the appropriate dimensions for different use cases or applications (e.g., mold frames 1102 designed for full-size panels, subpanels, quarter panels, etc., with varying thicknesses).

In FIG. 11B, the glass substrate 1002 is shown in the bottom mold frame 1102a.

In FIG. 11C, the mold frame 1102 is closed by aligning and placing the top mold frame or lid 1102b on the bottom mold frame 1102a.

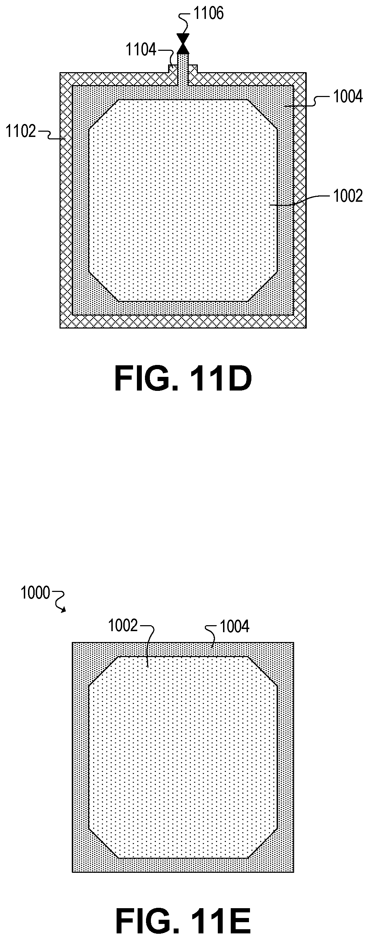

In FIG. 11D, the closed mold frame 1102 is filled with a wet organic material 1004, and the organic material 1004 is cured.

For example, a dispenser 1106 is used to dispense an organic material 1004 in wet/uncured (e.g., liquid) form into the closed mold frame 1102 via a dispensing valve 1104 on the closed mold frame 1102. In some embodiments, the organic material 1004 may be a liquid organic polymer, such as liquid prepreg. In this manner, when dispensed into the closed mold frame 1102, the organic material 1004 flows around the glass substrate 1002 and forms a shape or frame around the glass substrate 1002. In particular, the inner corners and edges of the organic frame 1004 are formed around the outer patterned corners and edges of the glass substrate 1002, thus forming complementary interlocking patterns on the respective corners and edges of the organic frame 1004 and the glass substrate 1002 (e.g., chamfered corners with complementary interlocking chamfer patterns, beveled edges with complementary interlocking bevel patterns).

The closed mold frame 1102 is then placed in an oven to cure the organic material 1004, thus forming a hardened organic frame 1004 around the glass substrate 1002.

In FIG. 11E, the hybrid substate 1000 (e.g., the interlocking glass substrate 1002 and organic frame 1004) is removed, separated, or disassembled from the mold frame 1102.

In some embodiments, the resulting hybrid substrate 1000 may be slightly larger than it should be. For example, with respect to a hybrid panel 1000, the resulting hybrid panel 1000 may be slightly larger than a full-size panel (e.g., 520x525 mm instead of 51Ox515 mm). As a result, the hybrid panel 1000 may be routed into the appropriate dimensions (e.g., 510x515 mm) by trimming one or more edges of the organic frame 1004.

Further, in some embodiments, the organic frame 1004 may be routed or cut to form one or more notches on the organic frame 1004 to identify the hybrid substrate 1000 (e.g., panel ID, type of substrate, orientation, etc.).

At this point, the hybrid substrate 1000 may be complete, and any remaining processing may be performed on the hybrid substrate 1000, such as via formation (e.g., forming through-glass vias (TGVs) through the glass core 1002), interconnect patterning (e.g., forming dielectric buildup layers and conductive layers, patterning the conductive layers into traces, forming vias), die attach, interconnect bump formation, singulation, etc. (e.g., as described further in connection with process flow 1600 of FIG. 16).

### Example Embodiments

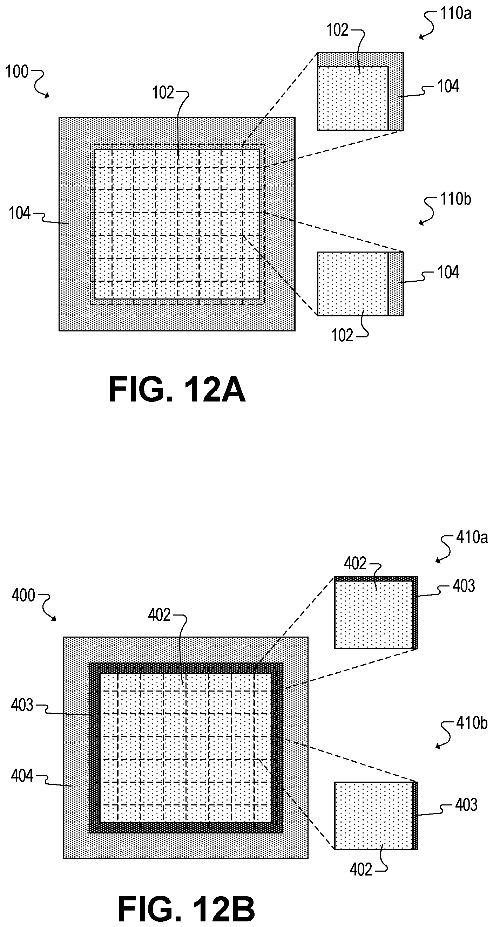

**FIGS. 12A-E** illustrate examples of unit-level hybrid substrates singulated from hybrid glass/organic panels. In the illustrated examples, only the unit-level hybrid substrates are shown. In actual embodiments, however, the unit-level hybrid substrates may include other elements (e.g., vias, traces, dies) and may be part of an IC package or PCB.

FIG. 12A shows plan views of unit-level substrates 110a,b singulated from a corner and a side of hybrid substrate 100, respectively. In the corner unit 110a, the organic layer/frame 104 extends around two edges of the glass core 102 in plan view. In the side unit 110b, the organic layer/frame 104 extends along one edge of the glass core 102 in plan view. In some embodiments, after singulation, the organic layer 104 may be organic residue (e.g., polyimide residue) extending along the one or more edges of the glass core 102.

FIG. 12B shows plan views of unit-level substrates 410a,b singulated from a corner and a side of hybrid substrate 400, respectively. In the corner unit 410a, the adhesive layer 403 extends around two edges of the glass core 402 in plan view. In the side unit 410b, the adhesive layer 403 extends along one edge of the glass core 402 in plan view. In some embodiments, depending on where the hybrid substrate 400 is diced, the respective substrate units 410a,b may also include portions of organic material 404 extending along one or more edges of the glass core 402 in plan view.

In some cases, there may be a signature of undulation in and over the adhesive layer 403 due to the surface tension of material remaining after dispensing/curing the adhesive layer 403 and adding additional (e.g., buildup) layers on top. For example, in cross-section view, there may be undulations in the adhesive layer 403 and portions of other layers formed over the adhesive layer 403 (e.g., similar to the undulation shown in the dispensed adhesive material 403 in FIG. 5C). At the panel level, this may be seen around the outer edges of the reconstituted panel 400. At the unit level, this may be seen around the outer edges of the singulated units 410a,b on the corners and edges of the reconstituted panel.

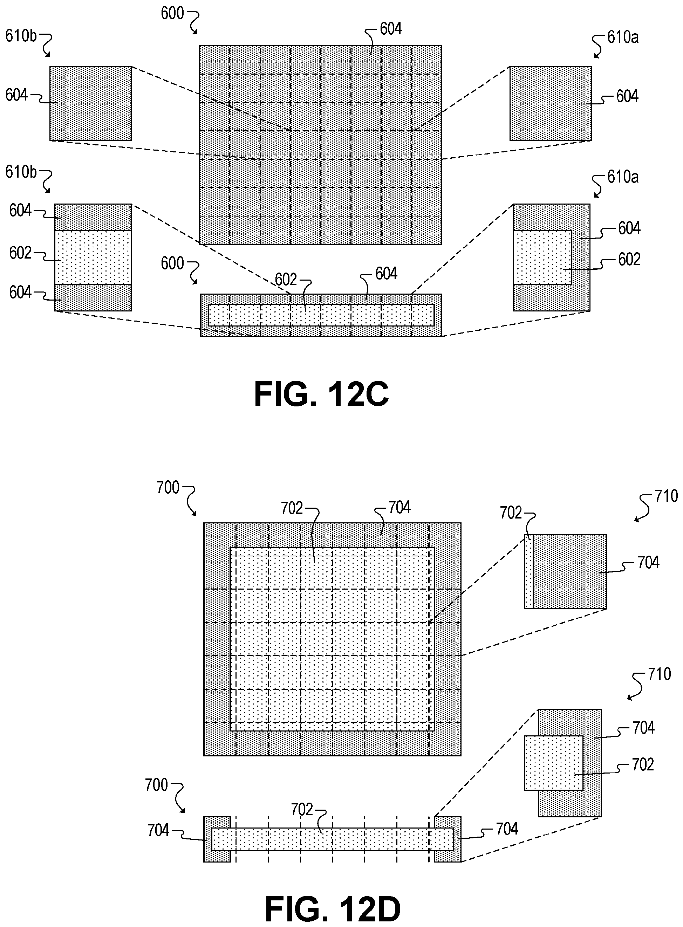

FIG. 12C shows plan and cross-section views of unit-level substrates 610a,b singulated from the side and middle of hybrid substrate 600, respectively. In the side unit 610a, the organic layer or shell 604 partially encapsulates the glass core 602, extending around the top and bottom surfaces and one side of the glass core 602 in cross-section view. In the middle unit 610b, the organic layer or shell 604 partially encapsulates the glass core 602, extending around the top and bottom surfaces of the glass core 602 in cross-section view.

FIG. 12D shows plan and cross-section views of a unit-level substrate 710 singulated from the side of hybrid substrate 700. In the side unit 710, the organic layer or frame 704 partially encapsulates the glass core 702. For example, in cross-section view, the organic layer/frame 704 extends around and encapsulates one side of the glass core 702 and portions of the top/bottom surfaces of the glass core 702. In plan view, the organic layer/frame 704 extends around one edge of the glass core 702 (e.g., partially around the perimeter of the glass core 702).

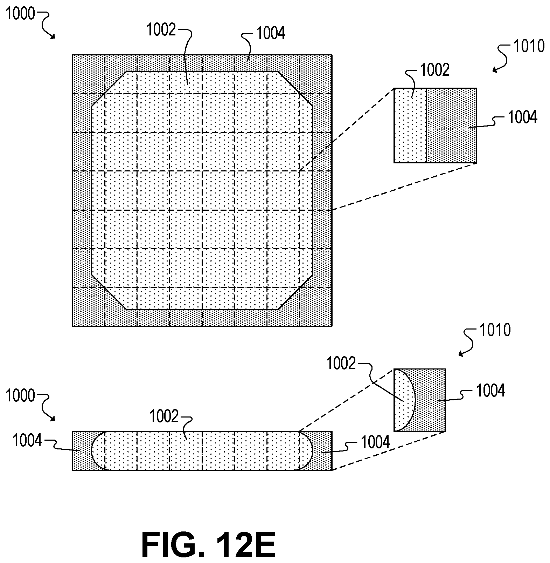

FIG. 12E shows plan and cross-section views of a unit-level substrate 1010 singulated from the side of hybrid substrate 1000. In plan view, the organic layer/frame 1004 extends along one edge of the glass core 1002 (at least partially around the perimeter of the glass core). In cross-section view, the organic layer/frame 1004 and the glass core 1002 have interlocking beveled edges.

**FIGS. 13A-C** illustrate an example of a glass substrate 1300. In particular, perspective, plan, and cross-section views of the glass substrate 1300 are shown in FIGS. 13A, 13B, and 13C, respectively. In some embodiments, the glass substrate 1300 may be included in the hybrid glass/organic substrates (e.g., hybrid substrates 100, 400, 600, 700, 1000, hybrid substrate units 110a,b, 410a,b, 610a,b, 710, 1010) and/or integrated circuit devices and systems (e.g., IC package 1400, systems 1500, 1510, IC device 1800, electronic device 1900) described throughout this disclosure.

In the illustrated embodiment, the glass substrate 1300 includes top and bottom surfaces/sides 1302a-b and four sides/edges 1304a-d. In various embodiments, the glass substrate 1300 may be a glass panel, subpanel, quarter panel, unit, or any other size or type of glass structure.

As used herein, the term "glass," when referring to a glass structure such as a glass substrate 1300 (e.g., glass panel, subpanel, quarter panel, unit, core, substrate, etc.), may refer to one or more layers of glass (e.g., a glass layer), a portion of a glass layer, or other structure of any glass material. In particular, the glass may be bulk glass or a solid volume/layer of glass, as opposed to, for example, materials that may include particles of glass, such as glass fiber reinforced polymers (e.g., substrates/boards constructed of glass fibers and an epoxy binder). Such bulk/solid glass materials are typically non-crystalline, often transparent, amorphous solids. In some embodiments, the glass may be an amorphous solid glass layer.

A glass substrate 1300 may be made of, or may include, any suitable glass material, including, without limitation, quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass.

In some embodiments, the glass substrate 1300 may be made of a material that includes elements such as silicon (Si) and oxygen (O), as well as any one or more of aluminum (Al), boron (B), magnesium (Mg), calcium (Ca), barium (Ba), tin (Sn), sodium (Na), potassium (K), strontium (Sr), phosphorus (P), zirconium (Zr), lithium (Li), titanium (Ti), or zinc (Zn).

In some embodiments, the glass substrate 1300 may include a material, e.g., any of the materials described above, with a weight percentage of silicon being at least about 0.5%, e.g., between about 0.5% and 50%, between about 1% and 48%, or at least about 23%. For example, if the glass material is fused silica, the weight percentage of silicon may be about 47%. In some embodiments, the glass substrate 1300 may include a material having at least 23% silicon and/or at least 26% oxygen by weight, and, in some further embodiments, the glass substrate 1300 may further include at least 5% aluminum by weight.

In some embodiments, the glass substrate 1300 may include any of the materials described above and may further include one or more additives, such as aluminum oxide (Al₂O₃), boron trioxide (B₂O₃), magnesium oxide (MgO), calcium oxide (CaO), strontium oxide (SrO), barium oxide (BaO), tin(IV) oxide (SnO₂), sodium oxide (Na₂O), potassium oxide (K₂O), diphosphorus trioxide (P₂O₃), zirconium dioxide (ZrO₂), lithium oxide (Li₂O), titanium (Ti), and zinc (Zn).

In some embodiments, the glass substrate 1300 may be a layer of glass that does not include an organic adhesive or an organic material. The glass substrate 1300 may be distinguished from, for example, a "prepreg" or "RF4" core of a PCB substrate which typically includes glass fibers embedded in a resinous organic material such as an epoxy. In such traditional cores/substrates including glass fibers and epoxy, the diameter of the glass fibers is generally in the range of 5 micrometers (microns or µm) to 200 µm.

In contrast, in some embodiments, the dimensions of the glass substrate 1300 (e.g., a glass core, glass layer, or overall glass substrate) may be in a range of about 10 millimeters (mm) per side to 250 mm per side (e.g., 10x10 mm to 250x250 mm). Further, in some embodiments, the dimensions of the glass substrate 1300 may be up to 600 mm on a side (e.g., a glass panel with dimensions of 510x515 mm or 600x600 mm).

In some embodiments, a cross-section of the glass substrate 1300 in an x-z plane, y-z plane, and/or x-y plane of an example coordinate system, may be substantially rectangular. In at least some such embodiments, in a top-down or plan view of the glass substrate 1300 (e.g., the x-y plane), the glass substrate 1300 may comprise a solid layer of glass substantially rectangular in shape and may have a first length in a range of 10 mm to 250 mm, and a second length in a range of 10 mm to 250 mm, the first length perpendicular to the second length.

In some embodiments, the glass substrate 1300 may be a layer of glass comprising a rectangular prism volume. In some such embodiments, the rectangular prism volume may have a first side and a second side perpendicular to the first side, the first side having a length in a range of 10 mm to 250 mm and the second side having a length in a range of 10 mm to 250 mm.

In some embodiments, the glass substrate 1300 may have a thickness (e.g., a dimension measured along the z axis) in a range of about 50 µm to 1.4 mm. In some embodiments, for example, the glass substrate 1300 may be a glass core substrate with a thickness of about 50 µm to 1.4 mm.

In some embodiments, the glass substrate 1300 may be a layer of glass having a thickness in a range of 50 µm to 1.4 mm, a first length in a range of 10 mm to 250 mm, and a second length in a range of 10 mm to 250 mm, the first length perpendicular to the second length.

In some embodiments, the glass substrate 1300 may be a multi-layer glass substrate (e.g., a coreless substrate), where a glass layer of the substrate 1300 has a thickness in a range of about 25 µm to 50 µm.

In some embodiments, the glass substrate 1300 may comprise a rectangular prism volume with sections (e.g., vias) removed and filled with at least one other material (e.g., metal). For example, the glass substrate 1300 may include a via extending from a first surface/side 1302a,b of the rectangular prism volume to a second surface/side 1302a,b of the rectangular prism volume, where the via includes a metal, thus forming a through-glass via (TGV) through the glass substrate 1300.

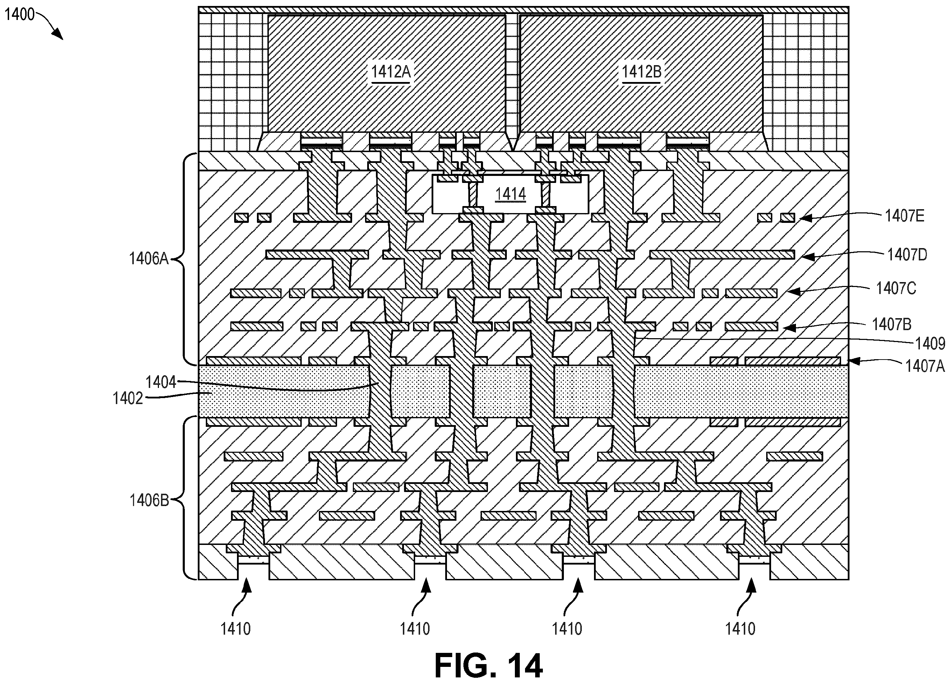

**FIG. 14** illustrates an example of a multi-die integrated circuit (IC) package 1400. In some embodiments, the core layer 1402 of IC package 1400 may be implemented using a hybrid glass/organic substrate according to any of the embodiments described herein (e.g., hybrid substrates 100, 400, 600, 700, 1000, hybrid substrate units 110a,b, 410a,b, 610a,b, 710, 1010).

The package 1400 includes a core layer 1402 and vias 1404 through the core layer 1402 (e.g., extending between the top and bottom surfaces of the core layer 1402). Buildup layers 1406 are formed on the top and bottom sides or surfaces of the core layer 1402, with buildup layers 1406A on the top side of the core layer 1402 and the buildup layers 1406B on bottom side of the core layer 1402. The buildup layers 1406 include metal traces in metallization layers (e.g., 1407A-E) and pillars/vias (e.g., 1409) between the metallization layers as shown to electrically couple components on the top of the package 1400 with the pads 1410 at the bottom of the package. For example, the layers 1406 may provide connections between the integrated circuit (IC) dies 1412 coupled to the top side of the package to a circuit board (e.g., a motherboard, main board, etc.) via the pads 1410 at the bottom of the package. The package 1400 also includes an interconnect bridge circuitry component 1414 located in the buildup layers 1406A that electrically couples the first IC die 1412A with the second IC die 1412B. The interconnect bridge circuitry component 1414 may include passive and/or active components to interconnect the IC dies 1412. As shown, the interconnect bridge circuitry component 1414 includes through silicon vias to connect a top side of the component 1414 with a bottom side. The interconnect bridge circuitry component 1414 may be an Intel^{®} embedded multi-die interconnect bridge with through silicon vias (EMIB-T) in certain embodiments.

The IC dies 1412A,B may include any type or combination of integrated circuit, including, without limitation, processing circuitry, communication circuitry, memory circuitry, and/or storage circuitry. In some embodiments, for example, the IC dies 1412A,B may include one or more systems-on-a-chip (SoCs), processing units (e.g., central processing units (CPUs), graphics processing units (GPUs), vision processing units (VPUs), neural processing units (NPUs), XPUs, microprocessors, microcontrollers), field-programmable gate arrays (FPGAs), application-specific integrated circuits (ASICs), network interface controllers (NICs), persistent storage devices, input/output (I/O) devices and controllers, memory devices and controllers, etc.

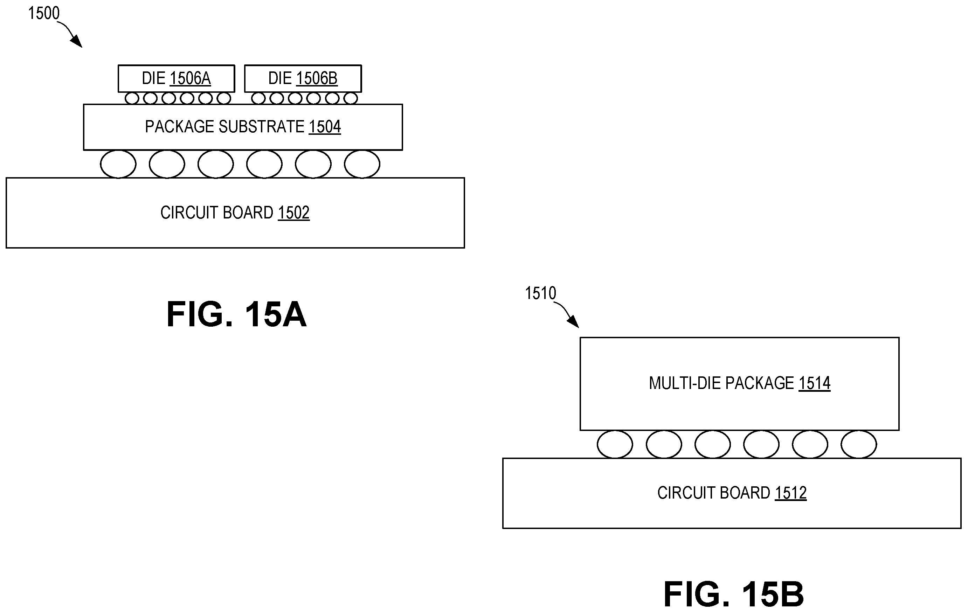

**FIGS. 15A-B** illustrate example systems 1500, 1510 that may incorporate the embodiments described herein. In some embodiments, for example, the package substrate 1504 of system 1500 and the multi-die package 1514 of system 1510 may include or may be implemented using a hybrid glass/organic substrate (e.g., hybrid substrate 100, 400, 600, 700, 1000, hybrid substrate units 110a,b, 410a,b, 610a,b, 710, 1010).

In FIG. 15A, example system 1500 includes a circuit board 1502, which may be implemented as a motherboard or main board of a computer system in some embodiments. The example system 1500 also includes a package substrate 1504 with integrated circuit dies 1506A, 1506B attached to the package substrate 1504. The dies 1506 may be packaged or unpackaged integrated circuit products that include one or more integrated circuit dies (e.g., dies 1702, dies 1412A,B) and/or one or more other suitable components. The respective dies 1506 can comprise one or more computing system components, such as one or more processor units (e.g., system-on-a-chip (SoC), processor core, central processing unit (CPU), graphics processing unit (GPU), XPU, accelerator, chipset processor), I/O controller, memory, or network interface controller. In some embodiments, the dies 1506 can comprise one or more additional active or passive devices such as capacitors, decoupling capacitors, resistors, inductors, fuses, diodes, transformers, sensors, electrostatic discharge (ESD) devices, and memory devices. In addition to comprising one or more processor units, the dies 1506 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets." The package substrate 1504 may provide electrical connections between the die 1506 and the circuit board 1502 and may include an embedded interconnect bridge circuitry die as described above.

In FIG. 15B, example system 1510 also includes a circuit board 1512, which may be implemented as a motherboard or main board of a computer system in some embodiments. The system 1510 also includes a multi-die package 1514, which includes multiple integrated circuits/dies (e.g., 1506), and interconnections between the dies in one or more metallization layers. The multi-die package 1514 may include, for example, one or more silicon interposers, one or more silicon bridges embedded in the package substrate. For example, the package 1514 may include an embedded interconnect bridge circuitry die (e.g., an Intel^{®} embedded multi-die interconnect bridge (EMIB) as described above.

The main circuit board 1502, 1512 of systems 1500, 1510 may provide electrical connections to other components of a computer system, e.g., memory, storage, network interfaces, peripheral devices, power supplies, etc. The main circuit board 1502, 1512 may include one or more traces and circuit components to provide interconnects between such computer system components.

In some embodiments, systems 1500, 1510 may be included in an electronic device, including, without limitation, a cell phone, a wearable device, a computer (e.g., desktop computer, laptop computer, server), a camera, a video playback device, a video game console, a display device, a vehicle control unit, an appliance, etc.

**FIG. 16** illustrates an example process flow 1600 for packaging integrated circuits on a hybrid glass/organic substrate core. In some embodiments, for example, the illustrated process flow may be used to form one or more integrated circuit (IC) packages (e.g., IC package 1400) on any of the hybrid glass/organic substrates described herein (e.g., hybrid substrates 100, 400, 600, 700, 1000, hybrid substrate units 110a,b, 410a,b, 610a,b, 710, 1010). It will be appreciated in light of the present disclosure that the illustrated process flow is only one example methodology for arriving at the example substrates, devices, and systems shown and described throughout this disclosure.

The steps of the illustrated process flow may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metal-organic chemical vapor deposition (MOCVD), molecular beam epitaxy (MBE), atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The flowchart begins at block 1602 by receiving a glass substrate (e.g., a glass panel, quarter panel, or unit). The glass substrate may be formed using any type of glass disclosed herein.

The flowchart then proceeds to block 1604 to form an organic frame or shell around the glass substrate, thus forming a hybrid glass/organic substrate. In some embodiments, for example, the organic frame or shell may be formed using any of the process flows described herein for forming hybrid glass/organic substrates (e.g., the process flows of FIGS. 2A-E, 5A-G, 8A-D, 9A-D, 11A-E). The resulting hybrid glass/organic substrate will serve as the core of a package substrate formed throughout the remaining blocks of the process flow.

The flowchart then proceeds to block 1606 to form an interconnect on the hybrid substrate. For example, through-glass vias (TGVs) may be formed through the hybrid substrate (e.g., by drilling holes through the glass core and filling them with metal). Moreover, one or more interleaving dielectric layers and conductive (e.g., metal) layers may be formed above and/or below the hybrid substrate, such that the conductive layers are separated by dielectric layers. The conductive layers may then be patterned (e.g., etched) into conductive traces, and vias may be formed (e.g., etched and filled) through the intervening dielectric layers to electrically couple the traces in different conductive layers. Further, conductive contacts (e.g., metal pads) electrically coupled to the vias and traces may be formed (e.g., on the surface, in a cavity, etc.) to enable other components to be electrically coupled to the package, such as the IC dies that are attached at block 1608. In some embodiments, one or more interconnect bridges may also be embedded in the package (e.g., within the dielectric layers) to provide an interconnect between certain components, such as the IC dies that are attached at block 1608. The conductive traces, vias, conductive contacts, and interconnect bridges collectively form an interconnect for the respective components that will be included in the package.

The flowchart then proceeds to block 1608 to attach one or more integrated circuit (IC) dies to the package. In particular, the IC dies may be assembled on the package such that conductive contacts (e.g., microbumps, pads) on the IC dies are electrically coupled to conductive contacts (e.g., pads) on the package, thus providing a first level interconnect (FLI) between the respective IC dies and the package.

In various embodiments, for example, the IC dies may be attached to the top or bottom surfaces of the package, or alternatively, the IC dies may be embedded in the package (e.g., within cavities formed in the glass core or the dielectric layers on the glass core). Moreover, the IC dies may be attached to the package using any suitable technique, including hybrid bonding the dies to the substrate (e.g., dielectric-to-dielectric and metal-to-metal bonds between dielectric layers with recessed metal (e.g., copper) pads on the respective dies and substrate), flip-chip bonding the dies to the substrate using microbumps (e.g., bonding microbumps on the face of the respective dies to corresponding pads on the substrate), etc.

The flowchart then proceeds to block 1610 to perform any remaining processing, such as inter-layer dielectric (ILD) filling, planarization, interconnect bump formation, etc. For example, conductive contacts (e.g., solder balls/bumps) may be formed on one or more surfaces of the substrate to provide a second level interconnect (SLI) to another component, such as another IC substrate or package, a printed circuit board (PCB), etc.

In panel-level or wafer-level process flows, the resulting panel or wafer may be diced to singulate the IC packages on the panel or wafer. The singulated IC packages may then be attached to, or incorporated in, another IC substrate or package, a PCB, an electronic device or system (e.g., systems 1500, 1510, IC device 1800, electronic device 1900), etc.

At this point, the flowchart may be complete. In some embodiments, however, the flowchart may restart and/or certain blocks may be repeated. For example, in some embodiments, the flowchart may restart at block 1602 to continue packaging integrated circuits on a hybrid glass/organic substrate.

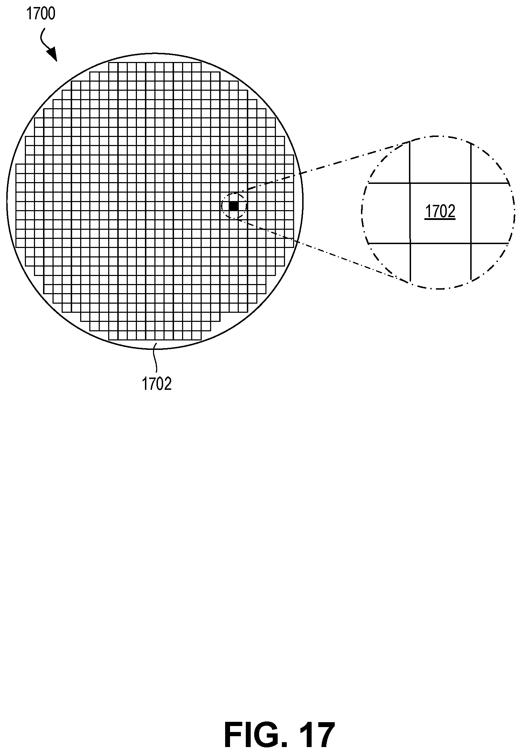

**FIG. 17** is a top view of a wafer 1700 and dies 1702 that may be included in, or may include, any of the embodiments disclosed herein. In some embodiments, for example, the respective dies 1702 may be included in an integrated circuit device or system (e.g., IC package 1400, systems 1500, 1510, IC device 1800) implemented using a hybrid glass/organic substrate according to any of the embodiments described throughout this disclosure (e.g., hybrid substrates 100, 400, 600, 700, 1000, hybrid substrate units 110a,b, 410a,b, 610a,b, 710, 1010).

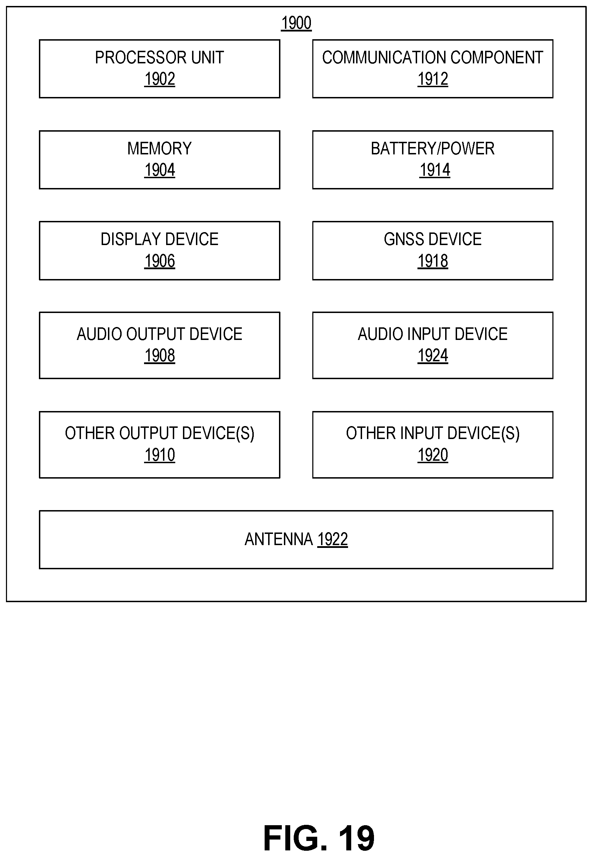

The wafer 1700 may be composed of semiconductor material and may include one or more dies 1702 having integrated circuit structures formed on a surface of the wafer 1700. The individual dies 1702 may be a repeating unit of an integrated circuit product that includes any suitable integrated circuit. After the fabrication of the semiconductor product is complete, the wafer 1700 may undergo a singulation process in which the dies 1702 are separated from one another to provide discrete "chips" of the integrated circuit product. The die 1702 may be any of the dies disclosed herein. The die 1702 may include one or more transistors, supporting circuitry to route electrical signals to the transistors, passive components (e.g., signal traces, resistors, capacitors, or inductors), and/or any other integrated circuit components. In some embodiments, the wafer 1700 or the die 1702 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1702. For example, a memory array formed by multiple memory devices may be formed on a same die 1702 as a processor unit (e.g., the processor unit 1902 of FIG. 19) or other logic that is configured to store information in the memory devices or execute instructions stored in the memory array. Various ones of the microelectronic assemblies disclosed herein may be manufactured using a die-to-wafer assembly technique in which some dies are attached to a wafer 1700 that include others of the dies, and the wafer 1700 is subsequently singulated.

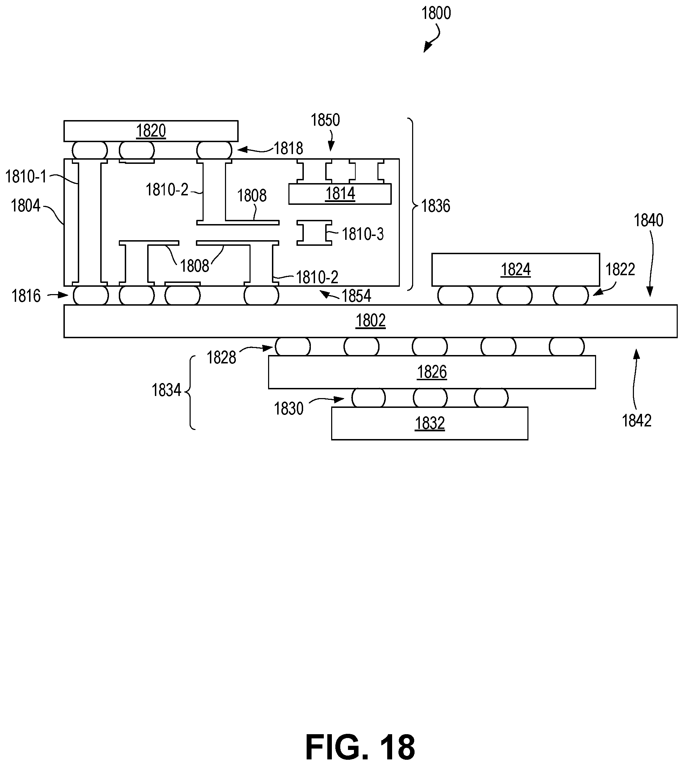

**FIG. 18** is a cross-sectional side view of an integrated circuit device assembly 1800 that may include any of the embodiments disclosed herein. In some embodiments, for example, the circuit board 1802, IC components 1820, 1824, 1826, 1832, interposers 1804, 1806, and/or embedded devices 1814 of the integrated circuit device assembly 1800 may include, or may be formed on, a hybrid glass/organic substrate according to any of the embodiments described throughout this disclosure (e.g., hybrid substrates 100, 400, 600, 700, 1000, hybrid substrate units 110a,b, 410a,b, 610a,b, 710, 1010).

In some embodiments, the integrated circuit device assembly 1800 may be a microelectronic assembly. The integrated circuit device assembly 1800 includes a number of components disposed on a circuit board 1802 (which may be a motherboard, system board, mainboard, etc.). The integrated circuit device assembly 1800 includes components disposed on a first face 1840 of the circuit board 1802 and an opposing second face 1842 of the circuit board 1802; generally, components may be disposed on one or both faces 1840 and 1842. Any of the integrated circuit components discussed below with reference to the integrated circuit device assembly 1800 may take the form of any suitable ones of the embodiments of the microelectronic assemblies disclosed herein.

In some embodiments, the circuit board 1802 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1802. In other embodiments, the circuit board 1802 may be a non-PCB substrate. The integrated circuit device assembly 1800 illustrated in FIG. 18 includes a package-on-interposer structure 1836 coupled to the first face 1840 of the circuit board 1802 by coupling components 1816. The coupling components 1816 may electrically and mechanically couple the package-on-interposer structure 1836 to the circuit board 1802, and may include solder balls (as shown in FIG. 18), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1816 may serve as the coupling components illustrated or described for any of the substrate assembly or substrate assembly components described herein, as appropriate.

The package-on-interposer structure 1836 may include an integrated circuit component 1820 coupled to an interposer 1804 by coupling components 1818. The coupling components 1818 may take any suitable form for the application, such as the forms discussed above with reference to the coupling components 1816. Although a single integrated circuit component 1820 is shown in FIG. 18, multiple integrated circuit components may be coupled to the interposer 1804; indeed, additional interposers may be coupled to the interposer 1804. The interposer 1804 may provide an intervening substrate used to bridge the circuit board 1802 and the integrated circuit component 1820.

The integrated circuit component 1820 may be a packaged or unpackaged integrated circuit product that includes one or more integrated circuit dies (e.g., the die 1702 of FIG. 17) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1820, a single monolithic integrated circuit die comprises solder bumps attached to contacts on the die. The solder bumps allow the die to be directly attached to the interposer 1804. The integrated circuit component 1820 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1820 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1820 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1820 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1804 may spread connections to a wider pitch or reroute a connection to a different connection. For example, the interposer 1804 may couple the integrated circuit component 1820 to a set of ball grid array (BGA) conductive contacts of the coupling components 1816 for coupling to the circuit board 1802. In the embodiment illustrated in FIG. 18, the integrated circuit component 1820 and the circuit board 1802 are attached to opposing sides of the interposer 1804; in other embodiments, the integrated circuit component 1820 and the circuit board 1802 may be attached to a same side of the interposer 1804. In some embodiments, three or more components may be interconnected by way of the interposer 1804.

In some embodiments, the interposer 1804 may be formed as a PCB, including multiple metal layers separated from one another by layers of dielectric material and interconnected by electrically conductive vias. In some embodiments, the interposer 1804 may be formed of an epoxy resin, a fiberglass-reinforced epoxy resin, an epoxy resin with inorganic fillers, a ceramic material, or a polymer material such as polyimide. In some embodiments, the interposer 1804 may be formed of alternate rigid or flexible materials that may include the same materials described above for use in a semiconductor substrate, such as silicon, germanium, and other group III-V and group IV materials. The interposer 1804 may include metal interconnects 1808 and vias 1810, including but not limited to through hole vias 1810-1 (that extend from a first face 1850 of the interposer 1804 to a second face 1854 of the interposer 1804), blind vias 1810-2 (that extend from the first or second faces 1850 or 1854 of the interposer 1804 to an internal metal layer), and buried vias 1810-3 (that connect internal metal layers).

In some embodiments, the interposer 1804 can comprise a silicon interposer. Through silicon vias (TSV) extending through the silicon interposer can connect connections on a first face of a silicon interposer to an opposing second face of the silicon interposer. In some embodiments, an interposer 1804 comprising a silicon interposer can further comprise one or more routing layers to route connections on a first face of the interposer 1804 to an opposing second face of the interposer 1804.

The interposer 1804 may further include embedded devices 1814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1804. The package-on-interposer structure 1836 may take the form of any of the package-on-interposer structures known in the art. In embodiments where the interposer is a non-printed circuit board

The integrated circuit device assembly 1800 may include an integrated circuit component 1824 coupled to the first face 1840 of the circuit board 1802 by coupling components 1822. The coupling components 1822 may take the form of any of the embodiments discussed above with reference to the coupling components 1816, and the integrated circuit component 1824 may take the form of any of the embodiments discussed above with reference to the integrated circuit component 1820.

The integrated circuit device assembly 1800 illustrated in FIG. 18 includes a package-on-package structure 1834 coupled to the second face 1842 of the circuit board 1802 by coupling components 1828. The package-on-package structure 1834 may include an integrated circuit component 1826 and an integrated circuit component 1832 coupled together by coupling components 1830 such that the integrated circuit component 1826 is disposed between the circuit board 1802 and the integrated circuit component 1832. The coupling components 1828 and 1830 may take the form of any of the embodiments of the coupling components 1816 discussed above, and the integrated circuit components 1826 and 1832 may take the form of any of the embodiments of the integrated circuit component 1820 discussed above. The package-on-package structure 1834 may be configured in accordance with any of the package-on-package structures known in the art.

**FIG. 19** is a block diagram of an example electrical device 1900 that may include one or more of the embodiments disclosed herein. For example, any suitable ones of the components of the electrical device 1900 may include one or more of the hybrid glass/organic substrates (e.g., hybrid substrates 100, 400, 600, 700, 1000, hybrid substrate units 110a,b, 410a,b, 610a,b, 710, 1010), integrated circuit device assemblies 1800, integrated circuit components 1820, or integrated circuit dies 1702 disclosed herein.

A number of components are illustrated in FIG. 19 as included in the electrical device 1900, but any one or more of these components may be omitted or duplicated, as suitable for the application. In some embodiments, some or all of the components included in the electrical device 1900 may be attached to one or more motherboards mainboards, or system boards. In some embodiments, one or more of these components are fabricated onto a single system-on-a-chip (SoC) die.

Additionally, in various embodiments, the electrical device 1900 may not include one or more of the components illustrated in FIG. 19, but the electrical device 1900 may include interface circuitry for coupling to the one or more components. For example, the electrical device 1900 may not include a display device 1906, but may include display device interface circuitry (e.g., a connector and driver circuitry) to which a display device 1906 may be coupled. In another set of examples, the electrical device 1900 may not include an audio input device 1924 or an audio output device 1908, but may include audio input or output device interface circuitry (e.g., connectors and supporting circuitry) to which an audio input device 1924 or audio output device 1908 may be coupled.

The electrical device 1900 may include one or more processor units 1902 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1900 may include a memory 1904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1904 may include memory that is located on the same integrated circuit die as the processor unit 1902. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1900 can comprise one or more processor units 1902 that are heterogeneous or asymmetric to another processor unit 1902 in the electrical device 1900. There can be a variety of differences between the processing units 1902 in a system in terms of a spectrum of metrics of merit including architectural, microarchitectural, thermal, power consumption characteristics, and the like. These differences can effectively manifest themselves as asymmetry and heterogeneity among the processor units 1902 in the electrical device 1900.

In some embodiments, the electrical device 1900 may include a communication component 1912 (e.g., one or more communication components). For example, the communication component 1912 can manage wireless communications for the transfer of data to and from the electrical device 1900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1912 may operate in accordance with other wireless protocols in other embodiments. The electrical device 1900 may include an antenna 1922 to facilitate wireless communications and/or to receive other wireless communications (such as AM or FM radio transmissions).

In some embodiments, the communication component 1912 may manage wired communications, such as electrical, optical, or any other suitable communication protocols (e.g., IEEE 802.3 Ethernet standards). As noted above, the communication component 1912 may include multiple communication components. For instance, a first communication component 1912 may be dedicated to shorter-range wireless communications such as Wi-Fi or Bluetooth, and a second communication component 1912 may be dedicated to longer-range wireless communications such as global positioning system (GPS), EDGE, GPRS, CDMA, WiMAX, LTE, EV-DO, or others. In some embodiments, a first communication component 1912 may be dedicated to wireless communications, and a second communication component 1912 may be dedicated to wired communications.

The electrical device 1900 may include battery/power circuitry 1914. The battery/power circuitry 1914 may include one or more energy storage devices (e.g., batteries or capacitors) and/or circuitry for coupling components of the electrical device 1900 to an energy source separate from the electrical device 1900 (e.g., AC line power).

The electrical device 1900 may include a display device 1906 (or corresponding interface circuitry, as discussed above). The display device 1906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1900 may include an audio output device 1908 (or corresponding interface circuitry, as discussed above). The audio output device 1908 may include any embedded or wired or wirelessly connected external device that generates an audible indicator, such speakers, headsets, or earbuds.

The electrical device 1900 may include an audio input device 1924 (or corresponding interface circuitry, as discussed above). The audio input device 1924 may include any embedded or wired or wirelessly connected device that generates a signal representative of a sound, such as microphones, microphone arrays, or digital instruments (e.g., instruments having a musical instrument digital interface (MIDI) output). The electrical device 1900 may include a Global Navigation Satellite System (GNSS) device 1918 (or corresponding interface circuitry, as discussed above), such as a Global Positioning System (GPS) device. The GNSS device 1918 may be in communication with a satellite-based system and may determine a geolocation of the electrical device 1900 based on information received from one or more GNSS satellites, as known in the art.

The electrical device 1900 may include other output device(s) 1910 (or corresponding interface circuitry, as discussed above). Examples of the other output device(s) 1910 may include an audio codec, a video codec, a printer, a wired or wireless transmitter for providing information to other devices, or an additional storage device.

The electrical device 1900 may include other input device(s) 1920 (or corresponding interface circuitry, as discussed above). Examples of the other input device(s) 1920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1900 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a display device (e.g., monitor, television), a set-top box, an entertainment control unit, a video game console, a video playback device, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1900 may be any other electronic device that processes data. In some embodiments, the electrical device 1900 may comprise multiple discrete physical components. Given the range of devices that the electrical device 1900 can be manifested as in various embodiments, in some embodiments, the electrical device 1900 can be referred to as a computing device or a computing system.

While the concepts of the present disclosure are susceptible to various modifications and alternative forms, specific embodiments thereof have been shown by way of example in the drawings and are described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features. Further, it should be understood that the various embodiments shown in the figures are illustrative representations and are not necessarily drawn to scale.

Moreover, the illustrations and/or descriptions of various embodiments may be simplified or approximated for ease of understanding, and as a result, they may not necessarily reflect the level of precision nor variation that may be present in actual embodiments. For example, while some figures generally indicate straight lines, right angles, and smooth surfaces, actual implementations of the disclosed embodiments may have less than perfect straight lines and right angles, and some features may have surface topography or otherwise be non-smooth, given real-world limitations of fabrication processes. Similarly, illustrations and/or descriptions of how components are arranged may be simplified or approximated for ease of understanding and may vary by some margin of error in actual embodiments (e.g., due to fabrication processes, etc.).

Unless otherwise specified, the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

The terms "substantially," "close," "approximately," "near," and "about," generally refer to being within +/- 10% of a target value (unless otherwise specified). Similarly, terms describing spatial relationships, such as "perpendicular," "orthogonal," or "coplanar," may refer to being substantially within the described spatial relationships (e.g., within +/- 10 degrees of orthogonality).

Certain terminology may also be used in the foregoing description for the purpose of reference only, and thus are not intended to be limiting. For example, terms such as "upper," "lower," "above," "below," "over," "under," "bottom," and "top" refer to directions in the drawings to which reference is made. Terms such as "front," "back," "rear," and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

The terms "over", "under", "between", "adjacent", "to", and "on" as used herein may refer to a relative position of one layer or component with respect to other layers or components. For example, one layer "over", "under", or "on" another layer, "adjacent" to another layer, or bonded "to" another layer may be directly in contact with the other layer or may have one or more intervening layers. One layer "between" layers may be directly in contact with the layers or may have one or more intervening layers.

The meaning of "a," "an," and "the" include plural references. The meaning of "in" includes "in" and "on."

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" may correspond to orthogonal planes within a cartesian coordinate system. For example, cross-sectional and profile views may be taken in the x-z plane, and plan views may be taken in the x-y plane. Where appropriate, drawings are labeled with axes to indicate the orientation of the figure.

The term "package" generally refers to a self-contained carrier of one or more dice, where the dice are attached to or embedded in the package substrate, and may be encapsulated for protection, with integrated or wire-bonded interconnects between the dice, along with leads, pins, or bumps located on the external portions of the package substrate. The package may contain a single die, or multiple dice, providing respective functions. The package may be mounted on a printed circuit board for interconnection with other packaged integrated circuits and discrete components, forming a larger circuit.

The term "cored" generally refers to a substrate of an integrated circuit package built upon a board, card, or wafer comprising a non-flexible stiff material. Typically, a small printed circuit board is used as a core, upon which integrated circuit device and discrete passive components may be soldered. Typically, the core has vias extending from one side to the other, allowing circuitry on one side of the core to be coupled directly to circuitry on the opposite side of the core. The core may also serve as a platform for building up layers of conductors and dielectric materials.

The term "coreless" generally refers to a substrate of an integrated circuit package having no core. The lack of a core may allow for higher-density package architectures, as the through-vias may have relatively large dimensions and pitch compared to high-density interconnects.

The term "land side" generally refers to the side of the substrate of the integrated circuit package closest to the plane of attachment to a printed circuit board, motherboard, or other package. This is in contrast to the term "die side", which generally refers to the side of the substrate of the integrated circuit package to which the die or dice are attached.

The terms "dielectric" and "dielectric material" generally refer to any type or number of non-electrically conductive materials. In some cases, dielectric material may be used to make up the structure of a package substrate. For example, dielectric material may be incorporated into an integrated circuit package as layers of laminate film or as a resin molded over integrated circuit dice mounted on the substrate.

The term "metallization" generally refers to metal layers formed on, over, and/or through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and may carry the same or similar meaning.

The term "bump" generally refers to a conductive layer or structure formed on a bond pad, which is typically made of solder or metal and has a round or curved shape, hence the term "bump".

The term "substrate" generally refers to a planar platform. A substrate may include dielectric and/or metallization structures. A substrate may mechanically support and electrically couple one or more IC dies on a single platform, with encapsulation of the one or more IC dies by a moldable dielectric material. A substrate may include bumps or pads as bonding interconnects on one or both sides. For example, one side of the substrate, generally referred to as the "die side", may include bumps or pads for chip or die bonding. The opposite side of the substrate, generally referred to as the "land side", may include bumps or pads for bonding the package to a printed circuit board.

The term "assembly" generally refers to a grouping of parts into a single functional unit. For example, certain parts may be permanently bonded together, integrated together, and/or mechanically assembled (e.g., where parts may be removable) into a functional unit.

The terms "coupled" or "connected" means a direct or indirect connection, such as a direct electrical, mechanical, magnetic, or fluidic connection between the things that are connected or an indirect connection, through one or more passive or active intermediary devices.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example A1 includes a substrate, comprising: a glass layer comprising a rectangular prism volume; and an organic frame around the glass layer, wherein the organic frame comprises a polyimide.

Example A2 includes the substrate of Example A1, wherein the organic frame extends around a perimeter of the glass layer in plan view.

Example A3 includes the substrate of Example A1, wherein the organic frame extends around edges of the glass layer in plan view.

Example A4 includes the substrate of any of Examples A1-A3, wherein the polyimide comprises a poly(benzoxazole imide).

Example A5 includes the substrate of any of Examples A1-A4, wherein the polyimide has a coefficient of thermal expansion (CTE) below 10 parts-per-million per Kelvin (ppm/K).

Example A6 includes the substrate of any of Examples A1-A5, wherein the CTE of the polyimide is within 1 ppm/K of a CTE of the glass layer.

Example A7 includes the substrate of any of Examples A1-A6, wherein top and bottom surfaces of the glass layer are laminated with dielectric film.

Example A8 includes the substrate of Example A7, wherein there is no dielectric film between the organic frame and the glass layer in cross-section view.

Example A9 includes the substrate of Example A7, wherein the dielectric film comprises Ajinomoto Build-up Film.

Example A10 includes the substrate of any of Examples A1-A9, further comprising one or more vias extending between top and bottom surfaces of the glass layer.

Example A11 includes the substrate of any of Examples A1-A10, wherein the glass layer comprises a solid layer of glass having a substantially rectangular shape in plan view.

Example A12 includes the substrate of any of Examples A1-A11, wherein the glass layer comprises silicon, oxygen, and aluminum.

Example A13 includes the substrate of any of Examples A1-A12, wherein the glass layer comprises at least 23 percent silicon by weight, at least 26 percent oxygen by weight, and at least 5 percent aluminum by weight.

Example A14 includes the substrate of any of Examples A1-A13, wherein the glass layer is not comprised of an organic adhesive or an organic material.

Example A15 includes an electronic device, comprising: a substrate comprising: a glass core, wherein the glass core comprises one or more vias extending between top and bottom surfaces of the glass core, and wherein the glass core is not comprised of an organic adhesive or an organic material; and an organic layer extending along one or more edges of the glass core in plan view, wherein the organic layer comprises a polyimide; and an integrated circuit (IC) die electrically coupled to the substrate.

Example A16 includes the electronic device of Example A15, wherein the organic layer further comprises polyimide residue extending along the one or more edges of the glass core.

Example A17 includes the electronic device of any of Examples A15-A16, wherein the polyimide comprises a poly(benzoxazole imide).

Example A18 includes the electronic device of any of Examples A15-A17, wherein the polyimide has a coefficient of thermal expansion (CTE) below 10 parts-per-million per Kelvin (ppm/K).

Example A19 includes the electronic device of Example A18, wherein the CTE of the polyimide is within 1 ppm/K of a CTE of the glass core.

Example A20 includes the electronic device of any of Examples A15-A19, wherein top and bottom surfaces of the glass core are laminated with dielectric film.

Example A21 includes the electronic device of Example A20, wherein there is no dielectric film between the organic layer and the glass core in cross-section view.

Example A22 includes the electronic device of any of Examples A15-A21, wherein the glass core has a thickness in a range of 50 µm to 1.4 mm, a first length in a range of 10 mm to 250 mm, and a second length in a range of 10 mm to 250 mm, the first length perpendicular to the second length.

Example A23 includes the electronic device of any of Examples A15-A22, wherein the glass core further comprises a solid layer of glass having a substantially rectangular shape in plan view.

Example A24 includes the electronic device of any of Examples A15-A23, wherein the glass core further comprises a rectangular prism volume.

Example A25 includes the electronic device of any of Examples A15-A24, wherein the glass core further comprises a rectangular prism volume having a first side and a second side perpendicular to the first side, the first side having a length in a range of 10 mm to 250 mm and the second side having a length in a range of 10 mm to 250 mm.

Example A26 includes the electronic device of any of Examples A15-A25, wherein the substrate further comprises: a plurality of dielectric layers over and under the glass core; a plurality of conductive traces and vias in the dielectric layers; and a plurality of conductive contacts on one or more surfaces of the substrate.

Example A27 includes the electronic device of any of Examples A15-A26, further comprising: a circuit board; and an IC package electrically coupled to the circuit board, wherein the IC package comprises the substrate and the IC die.

Example A28 includes the electronic device of any of Examples A15-A27, wherein the IC die comprises processing circuitry, communication circuitry, or memory circuitry.

Example A29 includes the electronic device of any of Examples A15-A28, wherein the electronic device is an IC package or the electronic device comprises an IC package.

Example A30 includes the electronic device of any of Examples A15-A29, wherein the electronic device is a cell phone, a wearable device, a computer, a server, a camera, a video playback device, a video game console, a display device, a vehicle control unit, or an appliance.

Example A31 includes a method, comprising: receiving a glass substrate, wherein the glass substrate comprises silicon, oxygen, and aluminum; and forming an organic frame along edges of the glass substrate, wherein the organic frame comprises a polyimide having a coefficient of thermal expansion (CTE) below 10 parts-per-million per Kelvin (ppm/K).

Example A32 includes the method of Example A31, wherein the polyimide comprises a poly(benzoxazole imide).

Example A33 includes the method of any of Examples A31-A32, wherein forming the organic frame along the edges of the glass substrate comprises: placing the glass substrate in a mold; filling the mold with the polyimide; and removing the mold from the glass substrate and the polyimide.

Example A34 includes the method of any of Examples A31-A33, further comprising laminating surfaces of the glass substrate with dielectric film.

Example A35 includes the method of any of Examples A31-A34, further comprising: forming a plurality of dielectric layers over and under the glass substrate; forming a plurality of conductive traces and vias in the dielectric layers; and forming a plurality of conductive contacts.

Example A36 includes the method of Example A35, further comprising attaching one or more integrated circuit dies to the conductive contacts.

Example A37 includes the method of any of Examples A31-A36, wherein the glass substrate is a glass panel.

Example A38 includes the method of any of Examples A31-A37, wherein the method is a method of forming a hybrid glass and organic substrate, wherein the hybrid glass and organic substrate comprises the glass substrate and the organic frame.

Example B1 includes a substrate, comprising: a glass layer comprising a rectangular prism volume; an organic frame extending around the glass layer; and an adhesive layer between the glass layer and the organic frame, wherein the adhesive layer comprises an adhesive material, wherein the adhesive material is cured, and wherein an uncured form of the adhesive material is flowable.

Example B2 includes the substrate of Example B1, wherein the organic frame and the adhesive layer extend around a perimeter of the glass layer in plan view.

Example B3 includes the substrate of Example B1, wherein the organic frame and the adhesive layer extend around edges of the glass layer in plan view.

Example B4 includes the substrate of any of Examples B1-B3, wherein the uncured form of the adhesive material is fluid.

Example B5 includes the substrate of any of Examples B1-B4, wherein the uncured form of the adhesive material has low viscosity.

Example B6 includes the substrate of any of Examples B1-B5, wherein the adhesive material comprises an epoxy.

Example B7 includes the substrate of any of Examples B1-B6, wherein the substrate has an undulation over the adhesive layer in cross-section view.

Example B8 includes the substrate of any of Examples B1-B7, wherein top and bottom surfaces of the glass layer are laminated with dielectric film.

Example B9 includes the substrate of Example B8, wherein the adhesive material and the dielectric film comprise different materials.

Example B10 includes the substrate of Example B8, wherein the dielectric film comprises Ajinomoto Build-up Film.

Example B11 includes the substrate of any of Examples B1-B10, further comprising one or more vias extending between top and bottom surfaces of the glass layer.

Example B12 includes the substrate of any of Examples B1-B11, wherein the glass layer comprises a solid layer of glass having a substantially rectangular shape in plan view.

Example B13 includes the substrate of any of Examples B1-B12, wherein the glass layer comprises silicon, oxygen, and aluminum.

Example B14 includes the substrate of any of Examples B1-B13, wherein the glass layer comprises at least 23 percent silicon by weight, at least 26 percent oxygen by weight, and at least 5 percent aluminum by weight.

Example B15 includes the substrate of any of Examples B1-B14, wherein the glass layer is not comprised of an organic adhesive or an organic material.

Example B16 includes an electronic device, comprising: a substrate comprising: a glass core, wherein the glass core comprises one or more vias extending between top and bottom surfaces of the glass core, and wherein the glass core is not comprised of an organic adhesive or an organic material; and an adhesive material extending along one or more edges of the glass core in plan view, wherein the adhesive material is cured, and wherein a wet form of the adhesive material is fluid; and an integrated circuit (IC) die electrically coupled to the substrate.

Example B17 includes the electronic device of Example B16, further comprising an organic material extending around one or more edges of the glass core in plan view, wherein the adhesive material is between the organic material and the glass core.

Example B18 includes the electronic device of any of Examples B16-B17, wherein the wet form of the adhesive material is flowable.

Example B19 includes the electronic device of any of Examples B16-B18, wherein the wet form of the adhesive material has low viscosity.

Example B20 includes the electronic device of any of Examples B16-B19, wherein the adhesive material comprises an epoxy.

Example B21 includes the electronic device of any of Examples B16-B20, wherein the substrate has an undulation over the adhesive material in cross-section view.

Example B22 includes the electronic device of any of Examples B16-B21, wherein top and bottom surfaces of the glass core are laminated with dielectric film.

Example B23 includes the electronic device of Example B22, wherein the adhesive material and the dielectric film comprise different materials.

Example B24 includes the electronic device of any of Examples B16-B23, wherein the glass core has a thickness in a range of 50 µm to 1.4 mm, a first length in a range of 10 mm to 250 mm, and a second length in a range of 10 mm to 250 mm, the first length perpendicular to the second length.

Example B25 includes the electronic device of any of Examples B16-B24, wherein the glass core further comprises a solid layer of glass having a substantially rectangular shape in plan view.

Example B26 includes the electronic device of any of Examples B16-B25, wherein the glass core further comprises a rectangular prism volume.

Example B27 includes the electronic device of any of Examples B16-B26, wherein the glass core further comprises a rectangular prism volume having a first side and a second side perpendicular to the first side, the first side having a length in a range of 10 mm to 250 mm and the second side having a length in a range of 10 mm to 250 mm.

Example B28 includes the electronic device of any of Examples B16-27, wherein the substrate further comprises: a plurality of dielectric layers over and under the glass core; a plurality of conductive traces and vias in the dielectric layers; and a plurality of conductive contacts on one or more surfaces of the substrate.

Example B29 includes the electronic device of any of Examples B16-B28, further comprising: a circuit board; and an IC package electrically coupled to the circuit board, wherein the IC package comprises the substrate and the IC die.

Example B30 includes the electronic device of any of Examples B16-B29, wherein the IC die comprises processing circuitry, communication circuitry, or memory circuitry.

Example B31 includes the electronic device of any of Examples B16-B30, wherein the electronic device is an IC package or the electronic device comprises an IC package.

Example B32 includes the electronic device of any of Examples B16-B31, wherein the electronic device is a cell phone, a wearable device, a computer, a server, a camera, a video playback device, a video game console, a display device, a vehicle control unit, or an appliance.

Example B33 includes a method, comprising: receiving a glass substrate and an organic frame, wherein the glass substrate comprises silicon, oxygen, and aluminum; arranging the glass substrate and the organic frame such that the glass substrate is substantially centered within the organic frame, wherein the organic frame extends around the glass substrate, and wherein the glass substrate and the organic frame are separated by a gap; and forming an adhesive layer in the gap between the glass substrate and the organic frame, wherein the adhesive layer comprises an adhesive material in cured form, and wherein the adhesive material is flowable in wet form.

Example B34 includes the method of Example B33, wherein the adhesive layer extends around edges of the glass substrate.

Example B35 includes the method of any of Examples B33-B34, wherein arranging the glass substrate and the organic frame such that the glass substrate is substantially centered within the organic frame comprises: placing the glass substrate and the organic frame on a carrier layer, wherein the carrier layer comprises a carrier substrate or a layer of release film.

Example B36 includes the method of any of Examples B33-B35, wherein forming the adhesive layer in the gap between the glass substrate and the organic frame comprises: filling the gap with the wet form of the adhesive material; and curing the adhesive material.

Example B37 includes the method of Example B36, wherein filling the gap with the wet form of the adhesive material comprises: dispensing the wet form of the adhesive material into the gap using a syringe dispenser.

Example B38 includes the method of Example B36, wherein filling the gap with the wet form of the adhesive material comprises: dispensing the wet form of the adhesive material into the gap using a squeegee blade and a stencil.

Example B39 includes the method of any of Examples B33-B38, wherein the adhesive material comprises an epoxy.

Example B40 includes the method of any of Examples B33-B39, further comprising laminating surfaces of the glass substrate with dielectric film.

Example B41 includes the method of any of Examples B33-B40, further comprising: forming a plurality of dielectric layers over and under the glass substrate; forming a plurality of conductive traces and vias in the dielectric layers; and forming a plurality of conductive contacts.

Example B42 includes the method of Example B41, further comprising attaching one or more integrated circuit dies to the conductive contacts.

Example B43 includes the method of any of Examples B33-B42, wherein the glass substrate is a glass panel.

Example B44 includes the method of any of Examples B33-B43, wherein the method is a method of forming a hybrid glass and organic substrate, wherein the hybrid glass and organic substrate comprises the glass substrate, the organic frame, and the adhesive layer.

Example C1 includes a substrate, comprising: a glass layer comprising a rectangular prism volume; and an organic layer around the glass layer, wherein the organic layer fully encapsulates the glass layer or the organic layer encapsulates edges of the glass layer.

Example C2 includes the substrate of Example C1, wherein the organic layer comprises a prepreg material.

Example C3 includes the substrate of Example C2, wherein the prepreg material comprises fiberglass and resin.

Example C4 includes the substrate of any of Examples C1-C3, wherein the organic layer comprises an organic shell, wherein the organic shell fully encapsulates the glass layer.

Example C5 includes the substrate of any of Examples C1-C3, wherein the organic layer comprises an organic frame, wherein the organic frame encapsulates the edges of the glass layer.

Example C6 includes the substrate of Example C5, wherein the organic frame extends around the edges of the glass layer in plan view.

Example C7 includes the substrate of Example C5, wherein the organic frame extends around a perimeter of the glass layer in plan view.

Example C8 includes the substrate of any of Examples C1-C7, further comprising one or more vias extending between top and bottom surfaces of the glass layer.

Example C9 includes the substrate of any of Examples C1-C8, wherein the glass layer comprises a solid layer of glass having a substantially rectangular shape in plan view.

Example C10 includes the substrate of any of Examples C1-C9, wherein the glass layer comprises silicon, oxygen, and aluminum.

Example C11 includes the substrate of any of Examples C1-C10, wherein the glass layer comprises at least 23 percent silicon by weight, at least 26 percent oxygen by weight, and at least 5 percent aluminum by weight.

Example C12 includes the substrate of any of Examples C1-C11, wherein the glass layer is not comprised of an organic adhesive or an organic material.

Example C13 includes an electronic device, comprising: a substrate comprising: a glass core, wherein the glass core comprises one or more vias extending between top and bottom surfaces of the glass core, and wherein the glass core is not comprised of an organic adhesive or an organic material; and an organic layer on the glass core, wherein the organic layer at least partially encapsulates the glass core; and an integrated circuit (IC) die electrically coupled to the substrate.

Example C14 includes the electronic device of Example C13, wherein the organic layer comprises a prepreg material.

Example C15 includes the electronic device of Example C14, wherein the prepreg material comprises fiberglass and resin.

Example C16 includes the electronic device of any of Examples C13-C15, wherein the organic layer comprises an organic shell, wherein the organic shell encapsulates at least top and bottom surfaces of the glass core.

Example C17 includes the electronic device of Example C16, wherein the organic shell further encapsulates one or more sides of the glass core.

Example C18 includes the electronic device of any of Examples C13-C15, wherein the organic layer comprises an organic frame, wherein the organic frame encapsulates one or more edges of the glass core.

Example C19 includes the electronic device of Example C18, wherein the organic frame extends around the one or more edges of the glass core in plan view.

Example C20 includes the electronic device of Example C18, wherein the organic frame extends at least partially around a perimeter of the glass core in plan view.

Example C21 includes the electronic device of any of Examples C13-C20, wherein the glass core has a thickness in a range of 50 µm to 1.4 mm, a first length in a range of 10 mm to 250 mm, and a second length in a range of 10 mm to 250 mm, the first length perpendicular to the second length.

Example C22 includes the electronic device of any of Examples C13-C21, wherein the glass core further comprises a solid layer of glass having a substantially rectangular shape in plan view.

Example C23 includes the electronic device of any of Examples C13-C22, wherein the glass core further comprises a rectangular prism volume.

Example C24 includes the electronic device of any of Examples C13-C23, wherein the glass core further comprises a rectangular prism volume having a first side and a second side perpendicular to the first side, the first side having a length in a range of 10 mm to 250 mm and the second side having a length in a range of 10 mm to 250 mm.

Example C25 includes the electronic device of any of Examples C13-C24, wherein the substrate further comprises: a plurality of dielectric layers over and under the glass core; a plurality of conductive traces and vias in the dielectric layers; and a plurality of conductive contacts on one or more surfaces of the substrate.

Example C26 includes the electronic device of any of Examples C13-C25, further comprising: a circuit board; and an IC package electrically coupled to the circuit board, wherein the IC package comprises the substrate and the IC die.

Example C27 includes the electronic device of any of Examples C13-C26, wherein the IC die comprises processing circuitry, communication circuitry, or memory circuitry.

Example C28 includes the electronic device of any of Examples C13-C27, wherein the electronic device is an IC package or the electronic device comprises an IC package.

Example C29 includes the electronic device of any of Examples C13-C28, wherein the electronic device is a cell phone, a wearable device, a computer, a server, a camera, a video playback device, a video game console, a display device, a vehicle control unit, or an appliance.

Example C30 includes a method, comprising: receiving a glass substrate; and forming an organic layer around the glass substrate, wherein the organic layer fully encapsulates the glass substrate or the organic layer encapsulates edges of the glass substrate.

Example C31 includes the method of Example C30, wherein the organic layer comprises a prepreg material.

Example C32 includes the method of Example C31, wherein the prepreg material comprises fiberglass and resin.

Example C33 includes the method of any of Examples C30-C32, wherein the organic layer comprises an organic shell, wherein the organic shell fully encapsulates the glass substrate.

Example C34 includes the method of Example C33, wherein forming the organic layer around the glass substrate comprises: arranging the glass substrate between a plurality of organic sheets; and pressing the organic sheets and the glass substrate using a hot press.

Example C35 includes the method of any of Examples C30-C32, wherein the organic layer comprises an organic frame, wherein the organic frame encapsulates the edges of the glass substrate.

Example C36 includes the method of Example C35, wherein the organic frame extends around the edges of the glass substrate in plan view.

Example C37 includes the method of Example C35, wherein the organic frame extends around a perimeter of the glass substrate in plan view.

Example C38 includes the method of Example C35, wherein forming the organic layer around the glass substrate comprises: arranging the glass substrate between a plurality of strips of organic frame; and pressing the strips of organic frame and the glass substrate using a hot press.

Example C39 includes the method of any of Examples C34 or C38, wherein forming the organic layer around the glass substrate further comprises: trimming one or more edges of the organic layer.

Example C40 includes the method of any of Examples C30-C39, further comprising: forming a plurality of dielectric layers over and under the glass substrate; forming a plurality of conductive traces and vias in the dielectric layers; and forming a plurality of conductive contacts.

Example C41 includes the method of Example C40, further comprising attaching one or more integrated circuit dies to the conductive contacts.

Example C42 includes the method of any of Examples C30-C41, wherein the glass substrate comprises silicon, oxygen, and aluminum.

Example C43 includes the method of any of Examples C30-C42, wherein the glass substrate is a glass panel.

Example C44 includes the method of any of Examples C30-C43, wherein the method is a method of forming a hybrid glass and organic substrate, wherein the hybrid glass and organic substrate comprises the glass substrate and the organic layer.

Example D1 includes a substrate, comprising: a glass layer comprising a rectangular prism volume; and an organic frame around the glass layer, wherein the organic frame extends around edges of the glass layer in plan view, and wherein the organic frame and the glass layer comprise interlocking corners and/or interlocking edges.

Example D2 includes the substrate of Example D1, wherein the interlocking corners comprise inner corners of the organic frame and outer corners of the glass layer, wherein the inner corners of the organic frame interlock with the outer corners of the glass layer in plan view.

Example D3 includes the substrate of Example D2, wherein the inner corners of the organic frame and the outer corners of the glass layer comprise complementary chamfers.

Example D4 includes the substrate of any of Examples D1-D3, wherein the interlocking edges comprise inner edges of the organic frame and outer edges of the glass layer, wherein the inner edges of the organic frame interlock with the outer edges of the glass layer in cross-section view.

Example D5 includes the substrate of Example D4, wherein the inner edges of the organic frame and the outer edges of the glass layer comprise complementary bevels.

Example D6 includes the substrate of any of Examples D1-D5, wherein the organic frame comprises an organic polymer, wherein the organic polymer is cured, and wherein an uncured form of the organic polymer is liquid.

Example D7 includes the substrate of any of Examples D1-D6, wherein the organic frame comprises a prepreg material.

Example D8 includes the substrate of Example D7, wherein the prepreg material comprises fiberglass and resin.

Example D9 includes the substrate of any of Examples D1-D8, wherein the organic frame has a coefficient of thermal expansion (CTE) below 10 parts-per-million per Kelvin (ppm/K).

Example D10 includes the substrate of any of Examples D1-D9, wherein a thickness of the glass layer is substantially the same as a thickness of the organic frame, and wherein surfaces of the glass layer are substantially flush with surfaces of the organic frame.

Example D11 includes the substrate of any of Examples D1-D10, wherein there is no gap and no material between the organic frame and the glass layer in cross-section view.

Example D12 includes the substrate of any of Examples D1-D11, wherein the organic frame further comprises one or more notches to identify a type of the substrate.

Example D13 includes the substrate of any of Examples D1-D12, wherein the organic frame extends around a perimeter of the glass layer in plan view.

Example D14 includes the substrate of any of Examples D1-D13, wherein: the substrate is a hybrid glass and organic panel; and the glass layer is a glass subpanel.

Example D15 includes the substrate of any of Examples D1-D14, further comprising one or more vias extending between top and bottom surfaces of the glass layer.

Example D16 includes the substrate of any of Examples D1-D15, wherein the glass layer comprises a solid layer of glass having a substantially rectangular shape in plan view.

Example D17 includes the substrate of any of Examples D1-D16, wherein the glass layer comprises silicon, oxygen, and aluminum.

Example D18 includes the substrate of any of Examples D1-D17, wherein the glass layer comprises at least 23 percent silicon by weight, at least 26 percent oxygen by weight, and at least 5 percent aluminum by weight.

Example D19 includes the substrate of any of Examples D1-D18, wherein the glass layer is not comprised of an organic adhesive or an organic material.

Example D20 includes an electronic device, comprising: a substrate comprising: a glass core, wherein the glass core comprises one or more vias extending between top and bottom surfaces of the glass core, and wherein the glass core is not comprised of an organic adhesive or an organic material; and an organic layer extending along one or more edges of the glass core in plan view, wherein the organic layer and the glass core comprise interlocking edges; and an integrated circuit (IC) die electrically coupled to the substrate.

Example D21 includes the electronic device of Example D20, wherein the interlocking edges comprise an inner edge of the organic layer and an outer edge of the glass core, wherein the inner edge of the organic layer interlocks with the outer edge of the glass core in cross-section view.

Example D22 includes the electronic device of Example D21, wherein the inner edge of the organic layer and the outer edge of the glass core comprise complementary bevels.

Example D23 includes the electronic device of any of Examples D20-D22, wherein the organic layer and the glass core further comprise interlocking corners.

Example D24 includes the electronic device of Example D23, wherein the interlocking corners comprise an inner corner of the organic layer and outer corner of the glass core, wherein the inner corner of the organic layer interlocks with the outer corner of the glass core in plan view.

Example D25 includes the electronic device of Example D24, wherein the inner corner of the organic layer and the outer corner of the glass core comprise complementary chamfers.

Example D26 includes the electronic device of any of Examples D20-D25, wherein the organic layer comprises an organic polymer, wherein the organic polymer is cured, and wherein a wet form of the organic polymer is liquid.

Example D27 includes the electronic device of any of Examples D20-D26, wherein the organic layer comprises a prepreg material.

Example D28 includes the electronic device of Example D27, wherein the prepreg material comprises fiberglass and resin.

Example D29 includes the electronic device of any of Examples D20-D28, wherein the organic layer has a coefficient of thermal expansion (CTE) below 10 parts-per-million per Kelvin (ppm/K).

Example D30 includes the electronic device of any of Examples D20-D29, wherein a thickness of the glass core is substantially the same as a thickness of the organic layer, and wherein surfaces of the glass core are substantially flush with surfaces of the organic layer.

Example D31 includes the electronic device of any of Examples D20-D30, wherein there is no gap and no material between the organic layer and the glass core in cross-section view.

Example D32 includes the electronic device of any of Examples D20-D31, wherein the organic layer extends at least partially around a perimeter of the glass core in plan view.

Example D33 includes the electronic device of any of Examples D20-D32, wherein the glass core further comprises a solid layer of glass having a substantially rectangular shape in plan view.

Example D34 includes the electronic device of any of Examples D20-D33, wherein the glass core further comprises a rectangular prism volume.

Example D35 includes the electronic device of any of Examples D20-D34, wherein the substrate further comprises: a plurality of dielectric layers over and under the glass core; a plurality of conductive traces and vias in the dielectric layers; and a plurality of conductive contacts on one or more surfaces of the substrate.

Example D36 includes the electronic device of any of Examples D20-D35, further comprising: a circuit board; and an IC package electrically coupled to the circuit board, wherein the IC package comprises the substrate and the IC die.

Example D37 includes the electronic device of any of Examples D20-D36, wherein the IC die comprises processing circuitry, communication circuitry, or memory circuitry.

Example D38 includes the electronic device of any of Examples D20-D37, wherein the electronic device is an IC package or the electronic device comprises an IC package.

Example D39 includes the electronic device of any of Examples D20-D38, wherein the electronic device is a cell phone, a wearable device, a computer, a server, a camera, a video playback device, a video game console, a display device, a vehicle control unit, or an appliance.

Example D40 includes a method, comprising: receiving a glass substrate; and forming an organic frame around the glass substrate, wherein the organic frame extends around edges of the glass substrate in plan view, and wherein the organic frame and the glass substrate comprise interlocking corners and/or interlocking edges.

Example D41 includes the method of Example D40, wherein the glass substrate comprises patterned corners in plan view and/or patterned edges in cross-section view.

Example D42 includes the method of Example D41, wherein the patterned corners are chamfered.

Example D43 includes the method of any of Examples D41-D42, wherein the patterned edges are beveled.

Example D44 includes the method of any of Examples D41-D43, wherein forming the organic frame around the glass substrate comprises: placing the glass substrate in a mold frame; filling the mold frame with an organic material in wet form; curing the organic material, wherein the organic frame is formed based on curing the organic material; and removing the glass substrate and the organic frame from the mold frame.

Example D45 includes the method of Example D44, wherein the organic material comprises a prepreg material.

Example D46 includes the method of any of Examples D44-D45, wherein filling the mold frame with the organic material in wet form comprises: dispensing the organic material in wet form into the mold frame via a dispense valve on the mold frame.

Example D47 includes the method of any of Examples D44-D46, wherein forming the organic frame around the glass substrate further comprises: trimming one or more edges of the organic frame.

Example D48 includes the method of any of Examples D40-D47, further comprising forming one or more notches on the organic frame, wherein the one or more notches identify a type of substrate.

Example D49 includes the method of any of Examples D40-D48, further comprising: forming a plurality of dielectric layers over and under the glass substrate; forming a plurality of conductive traces and vias in the dielectric layers; and forming a plurality of conductive contacts.

Example D50 includes the method of Example D49, further comprising attaching one or more integrated circuit dies to the conductive contacts.

Example D51 includes the method of any of Examples D40-D50, wherein the glass substrate comprises silicon, oxygen, and aluminum.

Example D52 includes the method of any of Examples D40-D51, wherein: the glass substrate is a glass subpanel; and the method is a method of forming a hybrid glass and organic panel, wherein the hybrid glass and organic substrate comprises the glass subpanel and the organic frame.

## Claims

1. A substrate, comprising:
a glass layer comprising a rectangular prism volume; and
an organic frame around the glass layer, wherein the organic frame comprises a polyimide.

2. The substrate of Claim 1, wherein the organic frame extends around edges of the glass layer in plan view.

3. The substrate of any of Claims 1-2, wherein the polyimide comprises a poly(benzoxazole imide).

4. The substrate of any of Claims 1-3, wherein the polyimide has a coefficient of thermal expansion (CTE) below 10 parts-per-million per Kelvin, ppm/K,.

5. The substrate of any of Claims 1-4, wherein the CTE of the polyimide is within 1 ppm/K of a CTE of the glass layer.

6. The substrate of any of Claims 1-5, wherein top and bottom surfaces of the glass layer are laminated with dielectric film.

7. The substrate of Claim 6, wherein there is no dielectric film between the organic frame and the glass layer in cross-section view.

8. The substrate of Claim 6, wherein the dielectric film comprises Ajinomoto Build-up Film.

9. The substrate of any of Claims 1-8, further comprising one or more vias extending between top and bottom surfaces of the glass layer.

10. The substrate of any of Claims 1-9, wherein the glass layer comprises a solid layer of glass having a substantially rectangular shape in plan view.

11. The substrate of any of Claims 1-10, wherein the glass layer comprises silicon, oxygen, and aluminum.

12. The substrate of any of Claims 1-11, wherein the glass layer is not comprised of an organic adhesive or an organic material.

13. An electronic device comprising a substrate as claimed in any of Claims 1-12.

14. A method of forming a substrate as claimed in any of Claims 1-12.

15. At least one machine-accessible storage medium having instructions stored thereon, wherein the instructions, when executed on a machine, cause the machine to perform a method or realize an apparatus as claimed in any preceding claim.
